(19) **Europäisches Patentamt / European Patent Office / Office européen des brevets**

(11) **EP 4 738 736 A1**

(12) **EUROPEAN PATENT APPLICATION**

(43) Date of publication:
06.05.2026 Bulletin 2026/19

(21) Application number: 25210212.4

(22) Date of filing: 21.10.2025

(51) International Patent Classification (IPC):
*H04L 1/00* (2006.01)    *H03M 13/09* (2006.01)
*H03M 13/00* (2006.01)    *H04L 1/1829* (2023.01)

(52) Cooperative Patent Classification (CPC):
**H04L 1/0061; H03M 13/091; H03M 13/6306;
H04L 1/0052; H04L 1/1614;** G06F 12/0223;
G06F 2212/174; H04L 1/1845

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: 05.11.2024 KR 20240155667

(71) Applicant: **Samsung Electronics Co., Ltd.**
**Suwon-si, Gyeonggi-do 16677 (KR)**

(72) Inventor: **BAE, Jimin**
**16677 Suwon-si (KR)**

(74) Representative: **Marks & Clerk LLP**
**15 Fetter Lane**
**London EC4A 1BW (GB)**

(54) **MODEM CHIP CAPABLE OF PERFORMING CYCLIC REDUNDANCY CHECK OF A TRANSPORT BLOCK ON A CODEBLOCK BASIS USING INTERNAL MEMORY, AND SYSTEM ON CHIP INCLUDING THE MODEM CHIP**

(57) A modem chip capable of receiving a codeword including a transport block including a plurality of code blocks, the modem chip including a hybrid automatic repeat request (HARQ) processing circuit configured to perform a HARQ-based processing operation including a first cyclic redundancy check and a second cyclic redundancy check with respect to the codeword, and an internal memory storing data generated during the second cyclic redundancy check. The plurality of code blocks are classified into a plurality of memory management groups each including at least two code blocks, and the internal memory includes a plurality of memory elements allocated to the plurality of memory management groups in a one-to-one correspondence.

FIG. 6A

EP 4 738 736 A1

**Description**

BACKGROUND

Aspects of the inventive concept relate to a modem chip forming a modem integrated circuit capable of decoding a codeword and performing a cyclic redundancy check (CRC) on the decoded codeword, and a system-on-chip including the modem integrated circuit.

In a communication system, a transmission device may transmit a codeword including a transport block (e.g., payload) composed of code blocks to a reception device. The codeword may include CRC bits for performing a CRC on each code block (hereinafter, referred to as a first CRC) and transport block cyclic redundancy check (TBCRC) bits for performing a CRC with respect to a transport block (hereinafter, referred to as a second CRC).

A modem of the reception device may determine whether a received codeword has been successfully decoded, by decoding the received codeword into units of decoded code blocks, performing the first CRC for each decoded code block, and performing the second CRC with respect to a decoded transport block.

When a code block that has failed in the first CRC exists among the decoded code blocks, the modem may request the transmission device to retransmit a corresponding code block in units of code block groups, and decoded code blocks that have passed the first CRC may be stored in an external memory. Thereafter, the modem may read the decoded code blocks from the external memory, generate a decoded transport block by concatenating a decoding result of the retransmitted code block with the read-out decoded code blocks, and perform the second CRC on the decoded transport block.

Because the external memory is also used by a processor other than the modem of the reception device, a bus connecting the external memory to each of the modem and the processor may be switched to a busy state by the processor, and thus communication through the bus between the modem and the external memory may be temporarily difficult. In addition, as the data size of the decoded code blocks stored in the external memory gradually increases with the advancement of communication technology, access to the external memory by the modem for a second CRC may increase a load on the bus and the external memory. Accordingly, a modem's second CRC on a decoded transport block may not be completed within a preset time, resulting in a degradation in the modem's performance.

SUMMARY

Aspects of the inventive concept provide a modem chip capable of performing a second cyclic redundancy check (CRC) based on remainders of target blocks corresponding to code blocks of a codeword and storing intermediate data generated in the second CRC in an internal memory, and a system on chip including the modem chip.

Aspects of the inventive concept provide a modem chip that stores intermediate data in an internal memory, based on memory management information, to efficiently use the internal memory in the second CRC, and a system on chip including the modem chip.

According to an aspect of the inventive concept, there is provided a modem chip capable of receiving a codeword including a transport block including a plurality of code blocks, the modem chip including a hybrid automatic repeat request (HARQ) processing circuit configured to perform a HARQ-based processing operation including a first cyclic redundancy check and a second cyclic redundancy check with respect to the codeword, and an internal memory storing data generated during the second cyclic redundancy check. The HARQ processing circuit includes a code block processing circuit configured to decode the plurality of code blocks into decoded code blocks and perform the first cyclic redundancy check on each of the decoded code blocks, and a codeword processing circuit configured to perform the second cyclic redundancy check on a decoded transport block by generating target blocks corresponding to the decoded code blocks based on a modular arithmetic using a polynomial for the second cyclic redundancy check. The plurality of code blocks are classified into a plurality of memory management groups each including at least two code blocks, and the internal memory includes a plurality of memory elements allocated to the plurality of memory management groups in a one-to-one correspondence.

According to another aspect of the inventive concept, there is provided a modem chip capable of communicating with an external memory via a bus, the modem chip including a HARQ processing circuit configured to perform a HARQ-based processing operation including a first cyclic redundancy check and a second cyclic redundancy check with respect to a codeword including a transport block including a plurality of code blocks, and an internal memory configured to store data generated during the second cyclic redundancy check. The HARQ processing circuit includes a code block processing circuit configured to decode the plurality of code blocks into decoded code blocks, perform the first cyclic redundancy check on the decoded plurality of code blocks, and store decoded code blocks, included in the decoded plurality of code blocks, that pass the first cyclic redundancy check into the external memory, and a codeword processing circuit configured to perform a second cyclic redundancy check on a decoded transport block by generating target blocks by respectively performing modular arithmetic with respect to each of the decoded code blocks. The plurality of code blocks are classified into a plurality of memory management groups each including at least two code blocks, and the internal memory includes a plurality of memory elements allocated to the plurality of memory management groups in a one-to-one correspondence.

According to another aspect of the inventive concept, there is provided a system on chip including a modem including an internal memory including a plurality of memory elements and configured to support a HARQ function, and a processor configured to perform a certain data processing operation. The modem is further configured to store, in the internal memory, intermediate data generated in a second cyclic redundancy check performed with respect to a transport block by using a target block corresponding to a decoded first code block that has passed a first cyclic redundancy check, based on memory management information corresponding to a first code block, and the memory management information includes an arrangement order of he first code block in a memory management group including the first code block and an address of a memory element allocated to the first code block.

At least some of the above and other features of the invention are set out in the claims.

BRIEF DESCRIPTION OF THE DRAWINGS

Embodiments will be more clearly understood from the following detailed description taken in conjunction with the accompanying drawings in which:

FIG. 1 is a schematic block diagram of a system on chip according to an embodiment;
FIG. 2 is a diagram for explaining a codeword;
FIG. 3 is a flowchart of an operation method of a hybrid automatic repeat request (HARQ) processing circuit according to an embodiment;
FIG. 4 is a block diagram of a modem according to an embodiment;
FIGS. 5A and 5B are diagrams for explaining use of internal memories in a second cyclic redundancy check (CRC), according to embodiments;
FIGS. 6A and 6B are diagrams for explaining a second CRC using an internal memory, according to an embodiment;
FIG. 7 is a flowchart of an operation method of a modem, according to an embodiment;
FIGS. 8A and 8B are diagrams for explaining a second CRC using an internal memory, according to an embodiment;
FIGS. 9A and 9B are diagrams for explaining a second CRC by a modem chip in detail, according to an embodiment;
FIGS. 10A and 10B are diagrams for explaining a second CRC using an internal memory, according to an embodiment;
FIGS. 11A and 11B are diagrams for explaining a second CRC by a modem chip in detail, according to an embodiment;
FIG. 12 is a diagram for explaining a relationship between a time period in which a first CRC is performed and a time period in which a second CRC is performed, according to an embodiment;
FIG. 13 is a block diagram of a CB concatenation & transport block cyclic redundancy check (TBCRC) circuit according to an embodiment;
FIG. 14 is a flowchart of an operation method of a HARQ processing circuit according to an embodiment;
FIG. 15 is a block diagram of an electronic device according to an embodiment; and
FIG. 16 is a view illustrating communication apparatuses configured to perform a second CRC, according to an embodiment.

DETAILED DESCRIPTION OF THE EMBODIMENTS

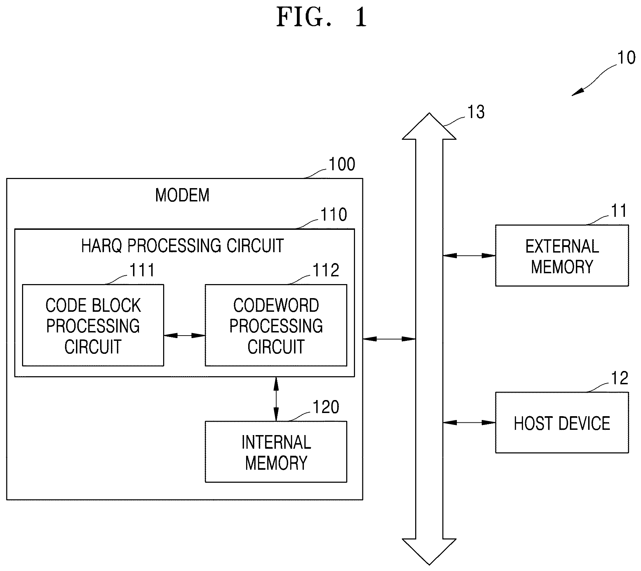

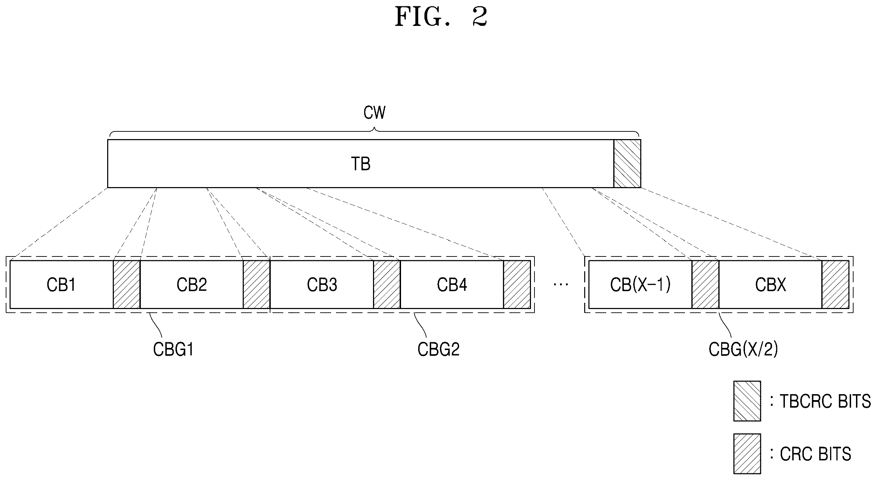

FIG. 1 is a schematic block diagram of a system on chip 10 according to an embodiment, and FIG. 2 is a drawing for explaining a codeword CW.

Referring to FIG. 1, the system on chip 10 may include a modem 100, an external memory 11, a host device 12, and a bus 13. The modem 100 may be implemented as a separate semiconductor chip and thus may correspond to a modem chip included in the system on chip 10. Herein, the modem 100 may be referred to as a modem chip. The modem 100, which is a processor configured to process a baseband signal, may also be referred to as a baseband processor. The system on chip 10 may be included in various devices that perform communication, and the system on chip 10 may further include a radio frequency (RF) chip. The RF chip may convert a signal (e.g. a high-frequency signal) received through an antenna module into a baseband signal and provide the baseband signal to the modem 100.

According to an embodiment, the external memory 11 is a memory that may be accessed by the modem 100 and the host device 12 via the bus 13, and may be shared by the modem 100 and the host device 12. Herein, the external memory 11 and the internal memory 120 are defined based on the modem 100, and thus the external memory 11 may be a memory physically disposed away from the modem 100 and the internal memory 120 may be a memory disposed inside the modem 100. For example, the external memory 11 may be realized as a volatile memory. In detail, the external memory 11 may be implemented as a dynamic random-access memory (DRAM), a synchronous DRAM (SDRAM), a double data rate (DDR) SDRAM, etc. According to some embodiments, the external memory 11 may be realized as a nonvolatile memory such as a NAND flash memory.

According to an embodiment, the host device 12 may be a device capable of accessing the external memory 11 via the bus 13. For example, the host device 12 may be any of various types of devices that process data, such as, a central processing unit (CPU), a graphics processing unit (GPU), and a neural processing unit (NPU).

According to an embodiment, the modem 100 may include a hybrid automatic repeat request (HARQ) processing circuit 110 and the internal memory 120. In various mobile communication standards such as long-term evolution (LTE) or new radio (NR), a HARQ function is defined. The HARQ processing circuit 110 may support a HARQ function according to the mobile communication standard. The HARQ processing circuit 110 may be implemented as hardware for performing embodiments to be described below, or may be implemented as software that is executed by a processor within the modem 100. According to some embodiments, the HARQ processing circuit 110 may also be implemented as a software/hardware combination. For example, the internal memory 120 may be realized as a volatile memory that is dedicated to the modem 100. In detail, the internal memory 120 may be realized as a cache memory such as a static RAM (SRAM). According to some embodiments, the internal memory 120 may be implemented as a DRAM, an SDRAM, a DDR SDRAM, or the like. For example, the capacity of the internal memory 120 may be less than the capacity of the external memory 11. For example, a maximum size of data stored as a result of performing a second cyclic redundancy check (CRC) in the internal memory 120 may be less than a maximum size of data stored as a result of performing a first CRC in the external memory 11.

According to an embodiment, the HARQ processing circuit 110 may include a code block processing circuit 111 and a codeword processing circuit 112. The code block processing circuit 111 may perform a processing operation in units of code blocks with respect to a received codeword (e.g., a transport block with error protection/control), and the codeword processing circuit 112 may perform a processing operation in units of codewords with respect to a result of processing a codeword of the code block processing circuit 111. Herein, an operation of the HARQ processing circuit 110 may be understood as an operation of the modem 100.

The configuration of the codeword will now be described by further referring to FIG. 2.

Referring further to FIG. 2, the codeword CW includes a transport block TB (e.g., payload, a unit of data, etc.), and may include transport block cyclic redundancy check (TBCRC) bits arranged at the end of the transport block TB in order to determine whether the transport block TB has been successfully decoded on a reception side (or a reception device). Additionally, the codeword CW may include first, second, third, fourth, ...., (X-1)th, and X-th (where X is an integer greater than or equal to 2) code blocks CB1, CB2, CB3, CB4,...., CB(X-1), and CBX. Each of the first through X-th code blocks CB1 through CBX may include CRC bits arranged at the end of the code block to determine whether a corresponding code block has been successfully decoded on the reception side (or the reception device). In an NR network, as the size of the codeword CW increases, an operation according to a HARQ function in communication based on NR networks may support retransmission in units of code block groups. For example, the first through X-th code blocks CB1 through CBX may be classified into a code block group. A code block group may comprise a plurality of code blocks.

In detail, a first code block group CBG1 may include the first and second code blocks CB1 and CB2, a second code block group CBG2 may include the third and fourth code blocks CB3 and CB4, and an (X/2)-th code block group CBG(X/2) may include the (X-1)-th and X-th code blocks CB(X-1) and CBX. When the first CRC performed on the first code block CB1 has failed, the first code block group CBG1 including the first code block CB1 may be retransmitted. However, this is only an embodiment, and thus aspects of the inventive concept are not limited thereto. The code block group may be defined to include three or more code blocks.

Although embodiments are described on the premise of a communication operation based on an NR network, they are merely examples, and embodiments are not limited thereto. It will be fully understood that embodiments are applicable to various types of networks that support the HARQ function. In addition, the structure of the codeword CW of FIG. 2 is schematically described for convenience of description, and accordingly it will be fully understood that embodiments are not limited by the structure of the codeword CW.

Referring back to FIG. 1, the code block processing circuit 111 may decode code blocks included in the received codeword, into units of decoded code blocks, and may perform a first CRC on each of the decoded code blocks. For example, the code block processing circuit 111 may decode each of the first through X-th code blocks CB1 through CBX of FIG. 2, and perform a first CRC by performing a modular arithmetic on each of the decoded first through X-th code blocks CB1 through CBX of FIG. 2 by using a first polynomial for the first CRC. The code block processing circuit 111 may determine that a code block of which a remainder obtained by the modular arithmetic is '0' (e.g., valid remainder) among the decoded first through X-th code blocks CB1 through CBX of FIG. 2 has passed the first CRC, and may determine that a code block of which a remainder is not '0' (e.g., invalid remainder) has failed the first CRC. The code block processing circuit 111 may provide the decoded code blocks that have passed the first CRC to the codeword processing circuit 112. The modem 100 may request the transmission side (or the transmission device) to retransmit a code block group including the code block that has failed the first CRC. At this time, the code block processing circuit 111 may store, in the external memory 11, decoded code blocks that have passed the first CRC.

According to an embodiment, the codeword processing circuit 112 may perform a second CRC on a decoded transport block. For example, the codeword processing circuit 112 may sequentially generate target blocks corresponding to the decoded code blocks, based on a modular arithmetic using a second polynomial for a second CRC, and may determine whether the second CRC has passed or failed, based on a final remainder corresponding to a last target block among the target blocks. Herein, a target block is defined as a block processed for the second CRC (i.e., a decoded code block that has passed a first cyclic redundancy check). Herein, the modular arithmetic may also be referred to as a remainder arithmetic. According to an embodiment, in the second CRC performed by the codeword processing circuit 112, a decoded transport block may be generated by concatenating decoded code blocks with each other, and remainders obtained by dividing the generated decoded transport block by the second polynomial may not be directly utilized, but remainders obtained by sequentially dividing target blocks corresponding to the decoded code blocks by a second polynomial may be indirectly utilized. Herein, a method of performing the second CRC by the codeword processing circuit 112 may be defined as a method based on the linear characteristics of the remainders corresponding to the target blocks. This will be described in detail later.

According to an embodiment, the second CRC performed by the codeword processing circuit 112 may be temporarily suspended until a code block that has failed the first CRC is retransmitted and processed by the code block processing circuit 111, and the internal memory 120 may store intermediate data including valid remainders generated via the second CRC. Herein, a storing operation may include at least one of a writing operation and an overwriting (or updating) operation.

According to an embodiment, the size of the intermediate data may be based on a second polynomial used in a modular arithmetic in the second CRC. According to an embodiment, the codeword processing circuit 112 may read intermediate data from the internal memory 120 in response to the retransmitted code block having passed the first CRC performed by the code block processing circuit 111, and may resume the second CRC, based on the read-out intermediate data.

In detail, the codeword processing circuit 112 may generate a first target block corresponding to the first code block CB1 of FIG. 2 decoded by the code block processing circuit 111, and may divide the first target block by a second polynomial to generate a first remainder. For example, the first target block may include the decoded first code block CB1 of FIG. 2 and zero bits (e.g., an n number of bits having the value of zero, where n is integer greater than or equal to 1). The codeword processing circuit 112 may generate a second target block corresponding to the second code block CB2 of FIG. 2 decoded by the code block processing circuit 111, and may divide the second target block by a second polynomial to generate a second remainder. For example, the second target block may include the decoded second code block CB2 of FIG. 2, the first remainder, and the zero bits. Then, the codeword processing circuit 112 may generate a third target block corresponding to the third code block CB3 of FIG. 2 decoded by the code block processing circuit 111, and may divide the third target block by a second polynomial to generate a third remainder. In this manner, the codeword processing circuit 112 may sequentially generate fourth through X-th target blocks corresponding to the fourth through X-th code blocks CB4 through CBX of FIG. 2. The X-th target block corresponds to the X-th code block CBX of FIG. 2 disposed at the very last position in the codeword CW of FIG. 2, and thus may be referred to as a last target block, and a remainder obtained by dividing the X-th target block by a second polynomial may be referred to as a final remainder. According to an embodiment, the first through X-th target blocks may have the same data length to be suitable for a modular arithmetic, and, to this end, the first through X-th target blocks may include different patterns (e.g., different numbers) of zero bits. The zero bits may pad the target blocks to be the same length. When, for example, the fourth code block CB4 of FIG. 2 has failed the first CRC and the remaining code blocks CB1 through CB3 and CB5 through CBX of FIG. 2 have passed the first CRC, the internal memory 120 may store intermediate data including valid remainders not associated with the fourth code block CB4 of FIG. 2 among first through X-th remainders corresponding to the first through X-th target blocks. Thereafter, when a retransmitted fourth code block is decoded and has passed the first CRC in the code block processing circuit 111, the codeword processing circuit 112 may read the intermediate data from the internal memory 120, and may update a final remainder corresponding to the X-th target block, based on a target block corresponding to the retransmitted decoded fourth code block and the read-out intermediate data. When the updated final remainder is '0', the codeword processing circuit 112 may determine that the decoded transport block has passed the second CRC.

According to an embodiment, when all of the decoded code blocks have passed the first CRC and have passed the second CRC using target blocks corresponding to the decoded code blocks, the codeword processing circuit 112 may concatenate the decoded code blocks to generate the decoded transport block (or a decoded codeword). The codeword processing circuit 112 may provide the generated decoded transport block to an upper layer. The codeword processing circuit 112 may read at least one of the decoded code blocks from the external memory 11 via the bus 13 to generate the decoded transport block.

In summary, when there is a code block in the codeword that requires retransmission, the code block processing circuit 111 may back up, in the external memory 11, decoded code blocks that have passed the first CRC. The codeword processing circuit 112 may sequentially receive decoded code blocks from the code block processing circuit 111, and may sequentially generate target blocks corresponding to the decoded code blocks and may use the generated target blocks to perform a second CRC on the decoded transport block. The codeword processing circuit 112 may store or back up intermediate data sequentially generated in the second CRC, in the internal memory 120. When it is determined that a result of the second CRC has passed, the codeword processing circuit 112 may read the decoded code blocks from the external memory 11 via the bus 13 to generate the decoded transport block. Through this operation, the number of accesses to the external memory 11 through the bus 13 of the modem 100 may be minimized, and a burden on the bus 13 and the external memory 11 also used by the host device 12 may be reduced.

The codeword processing circuit 112 does not wait until all processing operations (e.g., operations including decoding and a first CRC) for all code blocks in the code block processing circuit 111 are completed, and, whenever a processing operation for one code block is completed, the codeword processing circuit 112 may receive the processed code block from the code block processing circuit 111 and perform a second CRC. For example, the codeword processing circuit 112 may generate a target block by using a code block received from the code block processing circuit 111, and may perform a modular arithmetic on the target block to perform a second CRC. For example, a first time period in which a first CRC is performed by the code block processing circuit 111 may partially overlap with a second time period in which a second CRC is performed by the codeword processing circuit 112. Accordingly, the first CRC and the second CRC may be performed, at least partially, at the same time.

The modem 100 according to an embodiment may perform a second CRC on a decoded transport block by using target blocks corresponding to the decoded code blocks, and may store intermediate data generated in the second CRC in the internal memory 120 to thereby minimize access to the external memory 11 shared by the host device 12, thereby reducing the burden on the external memory 11 and the bus 13.

The modem 100 according to an embodiment may perform a rapid and effective processing operation independent of an operating state of the host device 12 by using the internal memory 120, which is dedicated to the modem 100, in a second CRC.

Embodiments in which the HARQ processing circuit 110 performs a second CRC on the decoded transport block by using the internal memory 120 have been described above, and embodiments for efficiently utilizing the internal memory 120 in a second CRC performed by the HARQ processing circuit 110 will now be described.

According to an embodiment, a plurality of code blocks included in a transport block may be classified into a plurality of memory management groups each including at least two code blocks, and a plurality of memory elements included in the internal memory 120 may be assigned to the plurality of memory management groups in a one-to-one correspondence.

According to an embodiment, a memory management group may conform to each code block group unit that is retransmitted at one time. For example, as in FIG. 2, similar to a code block group including two code blocks, a memory management group may be defined to include two code blocks. In detail, the first and second code blocks CB1 and CB2 included in the first code block group CBG1 may be classified into a first memory management group. According to some embodiments, a memory management group may be defined to contain at least two code blocks, independently of a code block group. According to some embodiments, one of the memory management groups may include a different number of code blocks than the number of code blocks included in each of the other memory management groups.

According to an embodiment, a storage capacity of a memory element may conform to a data size of a remainder (or intermediate data) corresponding to one code block from among the code blocks belonging to a memory management group allocated to the memory element. For example, the memory element may be memory of a predetermined size identified by an address location or a set of contiguous address locations. The predetermined size may be the same as or greater than a data size of a remainder (or intermediate data) corresponding to one code block from among the code blocks belonging to a memory management group.

According to an embodiment, the codeword processing circuit 112 may access the internal memory 120, based on memory management information indicating a relationship between the plurality of memory elements of the internal memory 120 and the plurality of code blocks, and may perform a second CRC on the decoded transport block. Herein, an access to memory (e.g., the internal memory 120, the external member 11, etc.) may be for writing (or overwriting) or reading data to or from the memory.

According to an embodiment, the memory management information may include a mapping table including code blocks, an arrangement order of the code blocks included in a memory management group, and addresses of memory elements allocated to the code blocks (or the memory management group). However, this is only an embodiment, and thus aspects of the inventive concept are not limited thereto. The memory management information may be implemented in various ways to effectively operate the internal memory 120.

The modem 100 according to an embodiment may efficiently utilize the internal memory 120 by storing, in the internal memory 120, intermediate data generated in the second CRC with respect to the decoded transport block, based on the memory management information, thereby effectively reducing the storage capacity (or size) of the internal memory 120 necessary for the second CRC.

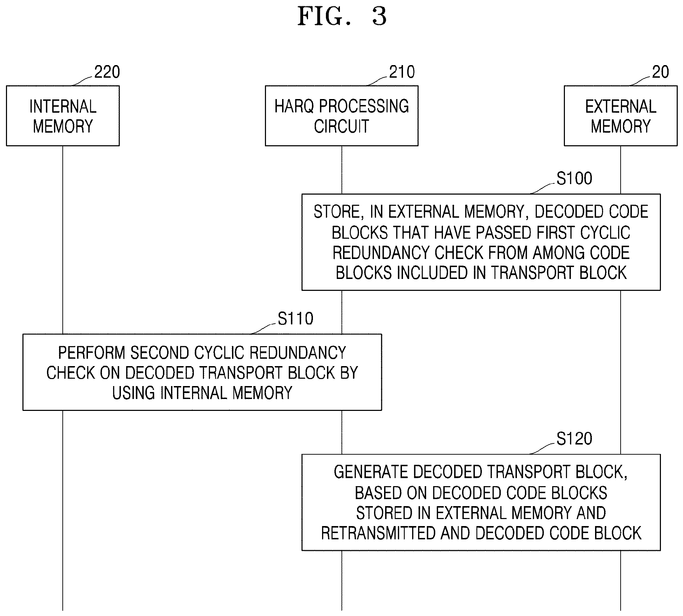

FIG. 3 is a flowchart of an operation method of a HARQ processing circuit 210 according to an embodiment. The HARQ processing circuit 210 is a component included in a modem chip, together with an internal memory 220, and an operation of the HARQ processing circuit 210 may be understood as an operation of the modem chip. The modem chip, the HARQ processing circuit 210, and the internal memory 220 may correspond, respectively, to the modem chip 100, the HARQ processing circuit 110, and the internal memory 120 discussed above with respect to FIG. 1. The external memory 20 illustrated in FIG. 3 may correspond to the external memory 11 discussed above with respect to FIG. 1.

Referring to FIG. 3, in operation S100, the HARQ processing circuit 210 may store, in the external memory 20, decoded code blocks that have passed a first CRC from among code blocks included in a transport block in the external memory 20. For example, the HARQ processing circuit 210 may decode the code blocks included in a transport block of a received codeword, and may perform a first CRC on the decoded code blocks. At this time, the HARQ processing circuit 210 may identify a code block that has failed the first CRC from among the decoded code blocks, and may request a transmission device to retransmit a code block group including the identified code block. In FIG. 3, it is described assuming that there is only one code block that has failed the first CRC. However, this is only an example, and embodiments are not limited thereto. For example, the HARQ processing circuit 210 may transmit, to the transmission device, an ACK message for code block groups including decoded code blocks that have passed the first CRC, and may transmit, to the transmission device, a NACK message for code block groups including decoded code blocks that have failed the first CRC. Because the HARQ processing circuit 210 needs a certain amount of time to receive and process the retransmitted code block group, the HARQ processing circuit 210 may store in an external memory the decoded code blocks that have passed the first CRC. In response to the NACK message, the transmission device may retransmit a code block group corresponding to the NACK message to the HARQ processing circuit 210. The HARQ processing circuit 210 may combine the retransmitted code block group with a previously received codeword, decode a retransmitted code block corresponding to the code block that has failed the first CRC in the combined codeword, and perform the first CRC.

In operation S110, the HARQ processing circuit 210 may perform a second CRC on the decoded transport block by using the internal memory 220. For example, instead of generating a decoded transport block by concatenating decoded code blocks that have passed the first CRC and determining whether the second CRC has been passed based on a remainder obtained by dividing the decoded transport block by a second polynomial (or a polynomial for the second CRC), the HARQ processing circuit 210 may perform the second CRC by sequentially generating target blocks corresponding to the decoded code blocks and determining whether the second CRC has been passed by using the generated target blocks. For example, the HARQ processing circuit 210 may perform a second CRC on the decoded transport block, based on a method of using target blocks corresponding to decoded code blocks, rather than directly using the decoded transport block in the second CRC. The HARQ processing circuit 210 may sequentially write or read the remainders corresponding to the target blocks to the internal memory 220 and perform a second CRC, based on the memory management information. In operation S100, the second CRC may be temporarily suspended by the code block that has failed the first CRC, and intermediate data necessary for resuming the second CRC may be stored in the internal memory 220. Thereafter, the HARQ processing circuit 210 may read the intermediate data from the internal memory 220, and resume the second CRC, based on the read-out intermediate data. For example, the HARQ processing circuit 210 may access the internal memory 220 at a faster speed than a speed for accessing the external memory 20. According to some embodiments, the HARQ processing circuit 210 may communicate with the internal memory 220 via an internal bus.

In operation S120, the HARQ processing circuit 210 may generate a decoded transport block, i.e., a decoded codeword (or decoded data in units of codewords), based on the decoded code blocks stored in the external memory 20 and the retransmitted and decoded code block. For example, when results of the first CRC and the second CRC with respect to the retransmitted and decoded code block have both passed, the HARQ processing circuit 210 may read the decoded code blocks from the external memory 20, and concatenate the read-out decoded code blocks with the retransmitted and decoded code block to generate the decoded transport block. The HARQ processing circuit 210 may output the decoded transport block to an upper layer (e.g., a media access control (MAC) layer).

In FIG. 3, operations S100 and S110 are performed sequentially. However, this is an example, and embodiments are not limited thereto, and operations S100 and S110 may be at least partially performed in parallel.

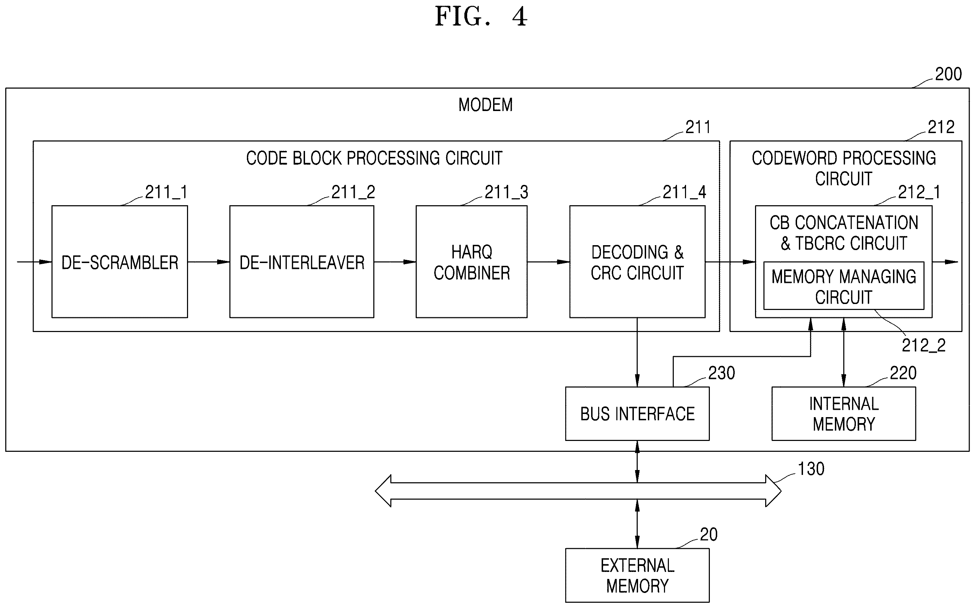

FIG. 4 is a block diagram of a modem 200 according to an embodiment. The modem 200 of FIG. 4 may be referred to as a modem chip, and the modem 200 may be connected to the external memory 20 through a bus 130.

Referring to FIG. 4, the modem 200 may include a code block processing circuit 211, a codeword processing circuit 212, the internal memory 220, and a bus interface 230. The code block processing circuit 211 may be a circuit for processing a received codeword in units of code blocks, and a codeword processing circuit 212 may be a circuit for processing the received codeword in units of codewords.

In FIG. 4, the codeword received by the code block processing circuit 211 may be data that has passed an analog-to-digital converter, a synchronization detector, a channel estimator, a channel equalizer, and a log likelihood ratio (LLR) de-mapper of the modem 200.

A descrambler 211_1 may descramble a codeword, and a deinterleaver 211_2 may deinterleave the codeword to align a plurality of code blocks included in the codeword into units of code blocks. A HARQ combiner 211_3 may provide code blocks received from the deinterleaver 211_2 to a decoding & CRC circuit 211_4, or may generate combined data by combining previous code blocks with a retransmitted code block (or a retransmitted code block group) and provide the combined data to the decoding & CRC circuit 211_4.

According to an embodiment, the decoding & CRC circuit 211_4 may decode the received code blocks into units of decoded code blocks, and may perform a first CRC on each of the decoded code blocks. The decoding & CRC circuit 211_4 may decode one code block and provide the decoded code block to the codeword processing circuit 212. The decoded code block provided to the codeword processing circuit 212 may be used in a second CRC which will be described later. When the decoding & CRC circuit 211_4 completes the first CRC on the decoded code block provided to the codeword processing circuit 212, the decoding & CRC circuit 211_4 may provide a result of the first CRC to the codeword processing circuit 212.

According to an embodiment, when there is a code block among the decoded code blocks that fails the first CRC and needs retransmission, the decoding & CRC circuit 211_4 may store code blocks among the decoded code blocks that have passed the first CRC, in the external memory 20 through the bus interface 230. For example, the bus interface 230 may store the decoded code blocks received from the decoding & CRC circuit 211_4, in the external memory 20 through the bus 130. According to some embodiments, instead of the decoding & CRC circuit 211_4, the codeword processing circuit 212 may store the code blocks that have passed a first CRC, in the external memory 20 through the bus interface 230.

According to an embodiment, the codeword processing circuit 212 may include a code block (CB) concatenation & TBCRC circuit 212_1. The CB concatenation & TBCRC circuit 212_1 may sequentially generate target blocks corresponding to the decoded code blocks received from the decoding & CRC circuit 211_4, and may perform a second CRC on a decoded transport block, based on remainders obtained by dividing the target blocks by a polynomial for a second CRC. The CB concatenation & TBCRC circuit 212_1 may temporarily suspend the second CRC until a code block that has failed the first CRC among the decoded code blocks is retransmitted and the retransmitted code block is received and processed by the decoding & CRC circuit 211_4.

According to an embodiment, the CB concatenation & TBCRC circuit 212_1 may include a memory management circuit 212_2. The memory management circuit 212_2 may sequentially store, in the internal memory 220, intermediate data generated in the second CRC based on the memory management information.

According to an embodiment, the memory management circuit 212_2 may one-to-one assign a plurality of memory elements included in the internal memory 220 to a plurality of memory management groups each including at least two code blocks. The memory management circuit 212_2 may store or manage the memory management information including allocation information about memory elements and information about an arrangement order of code blocks in the memory management group. The memory management circuit 212_2 is an example block embodied to clearly explain an operation of efficiently using the internal memory 220. According to some embodiments, an operation of the memory management circuit 212_2 may be replaced with an operation of the CB connection & TBCRC circuit 212_1 or the codeword processing circuit 212. In this case, the memory management circuit 212_2 may be omitted.

Thereafter, when the retransmitted code block is decoded and passes the first CRC, the CB concatenation & TBCRC circuit 212_1 may read intermediate data from the internal memory 120 via the memory management circuit 212_2 and may resume the second CRC. In detail, the CB concatenation & TBCRC circuit 212_1 may update a final remainder of a last target block, based on a target block corresponding to the read-out intermediate data and the retransmitted code block, and determine whether the second CRC has passed or failed, based on the updated final remainder.

According to an embodiment, when it is determined that a result of the second CRC has passed, the CB concatenation & TBCRC circuit 212_1 may read the decoded code blocks from the external memory 20 via the bus interface 230, and may concatenate the read-out decoded code blocks to the retransmitted and decoded code block to generate the decoded transport block. The CB concatenation & TBCRC circuit 212_1 may output the decoded transport block as codeword-unit data that have been successfully decoded.

According to some embodiments, the CB concatenation & TBCRC circuit 212_1 may be connected to the internal memory 220 via an internal bus.

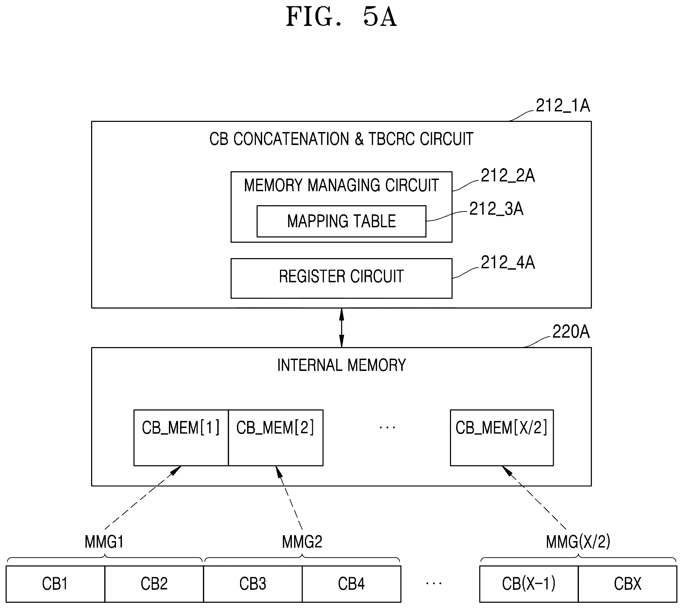

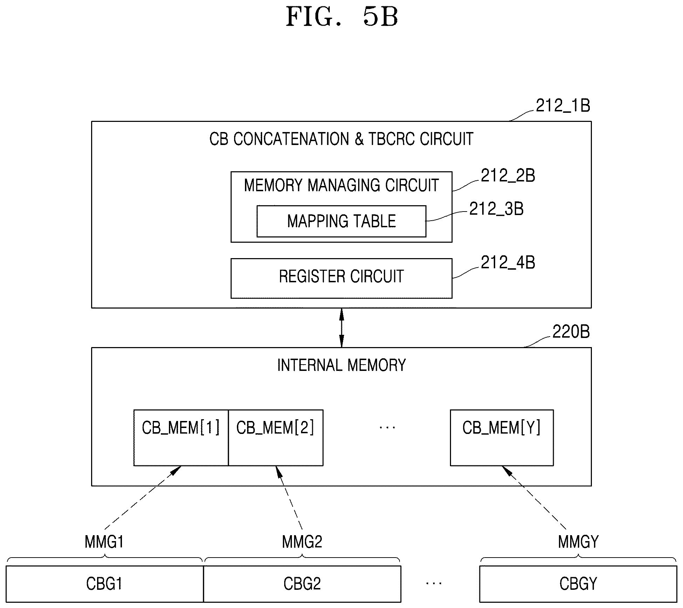

FIGS. 5A and 5B are diagrams for explaining embodiments of using internal memories 220A and 220B in the second CRC, according to an embodiment.

Referring to FIG. 5A, a CB concatenation & TBCRC circuit 212_1A may include a memory management circuit 212_2A and a register circuit 212_4A. According to some embodiments, the register circuit 212_4A may be implemented as a separate configuration from the CB concatenation & TBCRC circuit 212_1A. The internal memory 220A may include first, second, through to (X/2)th memory elements CB_MEM[1], CB_MEM[2], through to CB_MEM[X/2].

According to an embodiment, the internal memory 220A and the register circuit 212_4A may provide a space for storing intermediate data generated from the second CRC with respect to the decrypted transport block. For example, the internal memory 220A may be primarily used to store intermediate data generated in the second CRC, and the register circuit 212_4A may be auxiliary used to store the intermediate data generated in the second CRC.

According to an embodiment, a storage capacity of the internal memory 220A may be greater than that of the register circuit 212_4A.

According to an embodiment, the register circuit 212_4A may include at least one register. For example, the register may be implemented as a memory device, such as a flip-flop or a latch.

According to an embodiment, the memory management circuit 212_2A may manage first, second, through to (X/2)th memory management groups MMG1, MMG2, through to MMG(X/2), and the first, second, through to (X/2)th memory elements CB_MEM[1], CB_MEM[2], through to CB_MEM[X/2] allocated to the first, second, through to (X/2)th memory management groups MMG1, MMG2, through to MMG(X/2). For example, the memory management circuit 212_2A may classify the first, second, third, fourth, ...., (X-1)th, and X-th code blocks CB1, CB2, CB3, CB4,...., CB(X-1), and CBX into the first, second, through to (X/2)th memory management groups MMG1, MMG2, through to MMG(X/2). In detail, the memory management circuit 212_2A may group the first and second code blocks CB1 and CB2 into the first memory management group MMG1, group the third and fourth code blocks CB3 and CB4 into the second memory management group MMG2, and group the (X-1)th and X-th code blocks CB(X-1) and CBX into the (X/2)th memory management group MMG(X/2). The memory management circuit 212_2A may allocate the first through (X/2)th memory elements CB_MEM[1] through CB_MEM[X/2] to the first through (X/2)th memory management groups MMG1 through to MMG(X/2) in a one-to-one correspondence.

According to an embodiment, the memory management circuit 212_2A may store a mapping table 212_3A, and the mapping table 212_3A, which is included in the memory management information, may indicate a relationship between the first through (X/2)th memory management groups MMG1 through MMG(X/2), the first through X-th code blocks CB1 through CBX, and the first through (X/2)th memory elements CB_MEM[1] through CB_MEM[X/2].

According to an embodiment, the memory management circuit 212_2A may store intermediate data generated in the second CRC by the CB concatenation & TBCRC circuit 212_1A, based on the memory management information including the mapping table 212_3A, in one of the internal memory 220A and the register circuit 212_4A.

Referring to FIG. 5B, a CB concatenation & TBCRC circuit 212_1B may include a memory management circuit 212_2B and a register circuit 212_4B. The internal memory 220B may include first through to Y-th (where Y is an integer equal to or greater than 2) memory elements CB_MEM[1] through CB_MEM[Y].

According to an embodiment, the memory management circuit 212_2B may manage first, second, through to Y-th memory management groups MMG1, MMG2, through to MMGY, and the first through Y-th memory elements CB_MEM[1] through CB_MEM[Y] allocated to the first through Y-th memory management groups MMG1 through MMGY. For example, the memory management circuit 212_2B may manage the first, second, through to Y-th memory management groups MMG1, MMG2, through to MMGY to conform to first, second, through to Y-th code block groups CBG1, CBG2, through to CBGY. In detail, the first code block group CBG1 may be classified into the first memory management group MMG1, the second code block group CBG2 may be classified into the second memory management group MMG2, and the Y-th code block group CBGY may be classified into the Y-th memory management group MMGY. The memory management circuit 212_2B may allocate the first through Y-th memory elements CB_MEM[1] through CB_MEM[Y] to the first through Y-th memory management groups MMG1 through to MMGY in a one-to-one correspondence.

According to an embodiment, the memory management circuit 212_2B may store a mapping table 212_3B, and the mapping table 212_3B, which is included in the memory management information, may indicate a relationship between the first through Y-th memory management groups MMG1 through MMGY, the first through Y-th code block groups CBG1 through CBGY, and the first through Y-th memory elements CB_MEM[1] through CB_MEM[Y].

According to an embodiment, the memory management circuit 212_2B may store intermediate data generated in the second CRC by the CB concatenation & TBCRC circuit 212_1B, based on the memory management information including the mapping table 212_3B, in one of the internal memory 220B and the register circuit 212_4B.

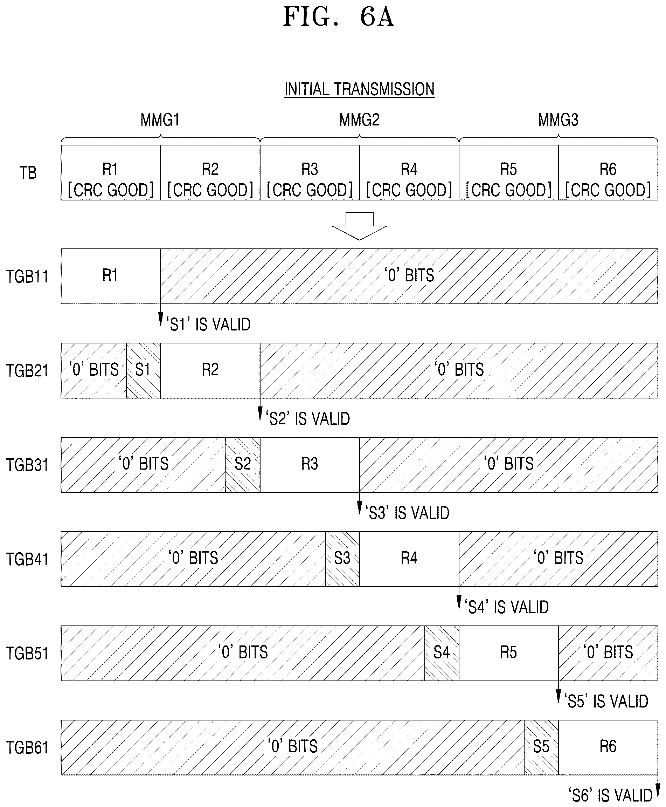

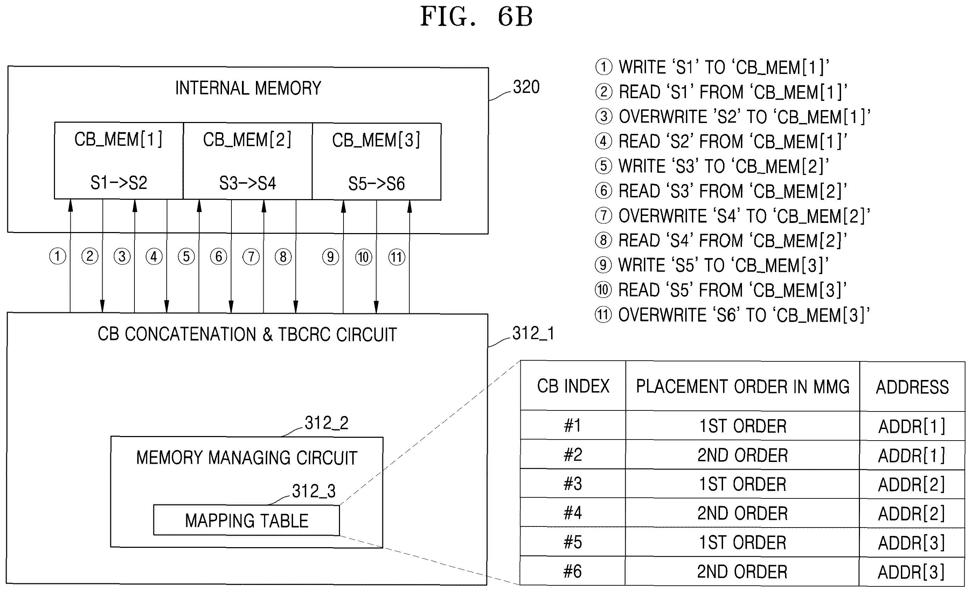

FIGS. 6A and 6B are diagrams for explaining a second CRC using an internal memory 320, according to an embodiment. In FIGS. 6A and 6B, it is assumed that a transport block TB includes first, second, third, fourth, fifth, and sixth code blocks R1, R2, R3, R4, R5, and R6, the first and second code blocks R1 and R2 are classified into a first memory management group MMG1, the third and fourth code blocks R3 and R4 are classified into a second memory management group MMG2, and the fifth and sixth code blocks R5 and R6 are classified into a third memory management group MMG3. The first memory management group MMG1 may be allocated to the first memory element CB_MEM[1], the second memory management group MMG2 may be allocated to the second memory element CB_MEM[2], and the third memory management group MMG3 may be allocated to the third memory element CB_MEM[3].

Referring to FIG. 6A, the transport block TB may be expressed as a sum of a plurality of polynomials as in Equation 1 below.

[Equation 1]

$$R = R1 + R2 + R3 + R4 + R5 + R6$$

A 'R' polynomial may correspond to the transport block TB, 'R1' polynomial may correspond to a first code block, a 'R2' polynomial may correspond to a second code block, a 'R3' polynomial may correspond to a third code block, a 'R4' polynomial may correspond to a fourth code block, a 'R5' polynomial may correspond to a fifth code block, and a 'R6' polynomial may correspond to a sixth code block. Accordingly, the polynomial R of the transport block TB may be expressed as a sum of a plurality of polynomials, wherein each polynomial corresponds to one of the code blocks.

When a modular arithmetic is performed on the transport block TB by using a '$g_{TBCRC}$' polynomial, the modular arithmetic may be expressed as Equation 2 below.

[Equation 2]

$$S = \text{remainder}\left(\frac{R}{g_{TBCRC}}\right) = remainder\left(\frac{R1}{g_{TBCRC}}\right) + remainder\left(\frac{R2}{g_{TBCRC}}\right) +$$
$$remainder\left(\frac{R3}{g_{TBCRC}}\right) + remainder\left(\frac{R4}{g_{TBCRC}}\right) + remainder\left(\frac{R5}{g_{TBCRC}}\right) +$$
$$remainder\left(\frac{R6}{g_{TBCRC}}\right)$$

A remainder obtained by dividing the 'R' polynomial by the '$g_{TBCRC}$' polynomial may conform to a sum of a remainder obtained by dividing the 'R1' polynomial by the '$g_{TBCRC}$' polynomial, a remainder obtained by dividing the 'R2' polynomial by the '$g_{TBCRC}$' polynomial, a remainder obtained by dividing the 'R3' polynomial by the '$g_{TBCRC}$' polynomial, a remainder obtained by dividing the 'R4' polynomial by the '$g_{TBCRC}$' polynomial, a remainder obtained by dividing the 'R5' polynomial by the '$g_{TBCRC}$' polynomial, and a remainder obtained by dividing the 'R6' polynomial by the '$g_{TBCRC}$' polynomial (or may conform to a remainder obtained by dividing the sum by the '$g_{TBCRC}$' polynomial). That is, the remainder may conform to a sum of the remainders obtained by dividing each polynomial by the '$g_{TBCRC}$' polynomial.

Taking into account the linear characteristics of the remainders as above, a second CRC according to an embodiment may be performed. Hereinafter, it is assumed that the initially-transmitted first, second, third, fourth, fifth, and sixth code blocks R1, R2, R3, R4, R5, and R6 are decoded into units of decoded code blocks by the decoding & CRC circuit 211_4 of FIG. 4, and that a first CRC has been completed. Accordingly, the respective data lengths of the first through sixth code blocks R1 through R6 may correspond to decoded data. It is also assumed that the first through sixth code blocks R1 through R6 are in a 'CRC GOOD' state, having been decoded and passed the first CRC.

Referring further to FIG. 6B, a CB concatenation & TBCRC circuit 312_1 may include a memory management circuit 312_2, and the memory management circuit 312_2 may store a mapping table 312_3. The mapping table 312_3 may include a field CB INDEX indicating an index of a code block, a field PLACEMENT ORDER IN MMG indicating an arrangement order (e.g., a placement order or position) of code blocks in a memory management group, and a field ADDRESS indicating an address of a memory element allocated to a memory management group. For example, in the mapping table 312_3, a first code block R1 may be mapped to a first arrangement order in the first memory management group MMG1 and an address ADDR[1] of the first memory element CB_MEM[1], a second code block R2 may be mapped to a second arrangement order in the first memory management group MMG1 and the address ADDR[1] of the first memory element CB_MEM[1], a third code block R3 may be mapped to a first arrangement order in the second memory management group MMG2 and an address ADDR[2] of the second memory element CB_MEM[2], a fourth code block R4 may be mapped to a second arrangement order in the second memory management group MMG2 and the address ADDR[2] of the second memory element CB_MEM[2], a fifth code block R5 may be mapped to a first arrangement order in the third memory management group MMG3 and an address ADDR[3] of the third memory element CB_MEM[3], and a sixth code block R6 may be mapped to a second arrangement order in the third memory management group MMG3 and an address ADDR[3] of the third memory element CB_MEM[3].

The memory management circuit 312_2 may sequentially store intermediate data generated by the CB concatenation & TBCRC circuit 312_1, which is to be described below, in the internal memory 320, based on the mapping table 312_3. The memory management circuit 312_2 may read intermediate data from the internal memory 320, based on the mapping table 312_3.

The CB concatenation & TBCRC circuit 312_1 may generate a first target block TGB11 including the first code block R1 and zero bits. For example, the CB concatenation & TBCRC circuit 312_1 may place the first code block R1 at the same position as a position in the transport block TB, and fill the area after the first code block R1 with the zero bits to generate the first target block TGB11.

The CB concatenation & TBCRC circuit 312_1 may divide the first target block TGB11 by a polynomial for the second CRC to generate a first remainder S1. Thereafter, the CB concatenation & TBCRC circuit 312_1 may determine, as valid data, the first remainder S1 corresponding to the first code block R1 that has passed the first CRC. The memory management circuit 312_2 may write the first remainder S1 to the first memory element CB_MEM[1], as in .

The memory management circuit 312_2 may read the first remainder S1 from the first memory element CB_MEM[1], as in (2), and the CB concatenation & TBCRC circuit 312_1 may generate a second target block TGB21 including the read-out first remainder S1, the second code block R2, and zero bits. For example, the CB concatenation and TBCRC circuit 312_1 may place the second code block R2 at the same position as a position in the transport block TB, place the first remainder S1 in front of the second code block R2, and fill the other portions of the transport block TB with the zero bits to generate the second target block TGB21.

The CB concatenation & TBCRC circuit 312_1 may divide the second target block TGB21 by a polynomial for the second CRC to generate a second remainder S2. Thereafter, the CB concatenation & TBCRC circuit 312_1 may determine, as valid data, the second remainder S2 corresponding to the second code block R2 that has passed the first CRC. The memory management circuit 312_2 may overwrite the second remainder S2 to the first memory element CB_MEM[1], as in ③. For example, the first remainder S1 previously written to the first memory element CB_MEM[1] is subsequently overwritten with the second remainder S2.

The memory management circuit 312_2 may read the second remainder S2 from the first memory element CB_MEM[1], as in ④, and the CB concatenation & TBCRC circuit 312_1 may generate a third target block TGB31 including the read-out second remainder S2, the third code block R3, and zero bits. For example, the CB concatenation & TBCRC circuit 312_1 may place the third code block R3 at the same position as a position in the transport block TB, place the second remainder S2 in front of the third code block R3, and fill the other portions of the transport block TB with the zero bits to generate the third target block TGB31.

The CB concatenation & TBCRC circuit 312_1 may divide the third target block TGB31 by a polynomial for the second CRC to generate a third remainder S3. Thereafter, the CB concatenation & TBCRC circuit 312_1 may determine, as valid data, the third remainder S3 corresponding to the third code block R3 that has passed the first CRC. The memory management circuit 312_2 may write the third remainder S3 to the second memory element CB_MEM[2], as in ⑤.

The memory management circuit 312_2 may read the third remainder S3 from the second memory element CB_MEM[2], as in ⑥, and the CB concatenation & TBCRC circuit 312_1 may generate a fourth target block TGB41 including the third remainder S3, the fourth code block R4, and zero bits. For example, the CB concatenation & TBCRC circuit 312_1 may place the fourth code block R4 at the same position as a position in the transport block TB, place the third remainder S3 in front of the fourth code block R4, and fill the other portions of the transport block TB with the zero bits to generate the fourth target block TGB41.

The CB concatenation & TBCRC circuit 312_1 may divide the fourth target block TGB41 by a polynomial for the second CRC to generate a fourth remainder S4. Thereafter, the CB concatenation & TBCRC circuit 312_1 may determine, as valid data, the fourth remainder S4 corresponding to the fourth code block R4 that has passed the first CRC. The memory management circuit 312_2 may overwrite the fourth remainder S4 to the second memory element CB_MEM[2], as in ⑦. For example, the third remainder S3 previously written to the second memory element CB_MEM[2] is subsequently overwritten with the fourth remainder S4.

The memory management circuit 312_2 may read the fourth remainder S4 from the second memory element CB_MEM[2], as in ⑧, and the CB concatenation & TBCRC circuit 312_1 may generate a fifth target block TGB51 including the read-out fourth remainder S4, the fifth code block R5, and zero bits. For example, the CB concatenation and TBCRC circuit 312_1 may place the fifth code block R5 at the same position as a position in the transport block TB, place the fourth remainder S4 in front of the fifth code block R5, and fill the other portions of the transport block TB with the zero bits to generate the fifth target block TGB51.

The CB concatenation & TBCRC circuit 312_1 may divide the fifth target block TGB51 by a polynomial for the second CRC to generate a fifth remainder S5. Thereafter, the CB concatenation & TBCRC circuit 312_1 may determine, as valid data, the fifth remainder S5 corresponding to the fifth code block R5 that has passed the first CRC. The memory management circuit 312_2 may write the fifth remainder S5 to the third memory element CB_MEM[3], as in ⑨.

The memory management circuit 312_2 may read the fifth remainder S5 from the third memory element CB_MEM[3], as in ⑩, and the CB concatenation & TBCRC circuit 312_1 may generate a sixth target block TGB61 including the read-out fifth remainder S5, the sixth code block R6, and zero bits. For example, the CB concatenation & TBCRC circuit 312_1 may place the sixth code block R6 at the same position as a position in the transport block TB, place the fifth remainder S5 in front of the sixth code block R6, and fill the other portions of the transport block TB with the zero bits to generate the sixth target block TGB61.

The CB concatenation & TBCRC circuit 312_1 may divide the sixth target block TGB61 by a polynomial for the second CRC to generate a sixth remainder S6. Thereafter, the CB concatenation & TBCRC circuit 312_1 may determine, as valid data, the sixth remainder S6 corresponding to the sixth code block R6 that has passed the first CRC. The memory management circuit 312_2 may overwrite the sixth remainder S6 to the third memory element CB_MEM[3], as in ⑪. For example, the fifth remainder S5 previously written to the third memory element CB_MEM[3] is subsequently overwritten with the sixth remainder S6.

The sixth target block TGB61 is a last target block, and the sixth remainder S6 corresponding to the sixth target block TGB61 may correspond to a final remainder. The CB concatenation & TBCRC circuit 312_1 may determine whether the second CRC with respect to the decoded transport block has passed or failed, based on the sixth remainder S6.

As such, in a time period when a second CRC is performed, the internal memory 320 may be efficiently operated so that either the first remainder S1 or the second remainder S2 is stored in the first memory element CB_MEM[1], either the third remainder S3 or the fourth remainder S4 is stored in the second memory element CB_MEM[2], and either the fifth remainder S5 or the sixth remainder S6 is stored in the third memory element CB_MEM[3].

However, the operations ① through ⑪ disclosed in FIG. 6B are merely examples to help understanding of the embodiments, and thus the embodiments are not limited thereto. Some operations may be omitted or other operations may be added.

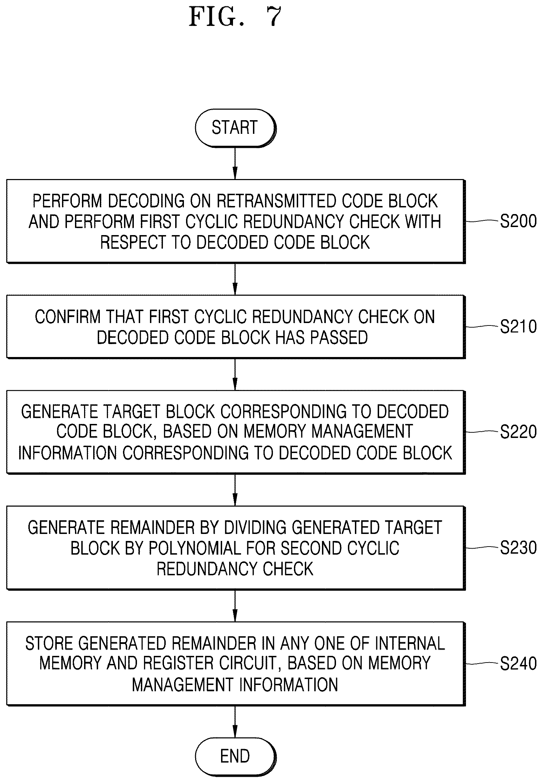

FIG. 7 is a flowchart of an operation method of a modem, according to an embodiment. In FIG. 7, it is assumed that the modem receives a retransmitted code block because the first CRC with respect to an arbitrary decoded code block has failed.

Referring to FIG. 7, in operation S200, the modem may perform decoding on the retransmitted code block and perform a first CRC on the decoded code block. The decoded code block in operation S200 may correspond to a result of decoding the retransmitted code block.

In operation S210, the modem may confirm that the first CRC on the decoded code block has passed. For example, the modem may perform a modular arithmetic on the decoded code block by using a first polynomial to generate a remainder, and may confirm that the first CRC has passed, based on the generated remainder.

In operation S220, the modem may generate a target block corresponding to the decoded code block, based on memory management information corresponding to the decoded code block. For example, the modem may read intermediate data stored in an internal memory or register circuit, based on the memory management information corresponding to the decoded code block, and may generate a target block corresponding to the decoded code block, based on the read-out intermediate data.

In operation S230, the modem may generate a remainder by dividing the target block generated in operation S220 by a polynomial for a second CRC. For example, the remainder generated in operation S230, which is valid, may be stored in any one of the internal memory and the register circuit.

In operation S240, the modem may store the remainder generated in operation S230, in any one of the internal memory and the register circuit, based on the memory management information.

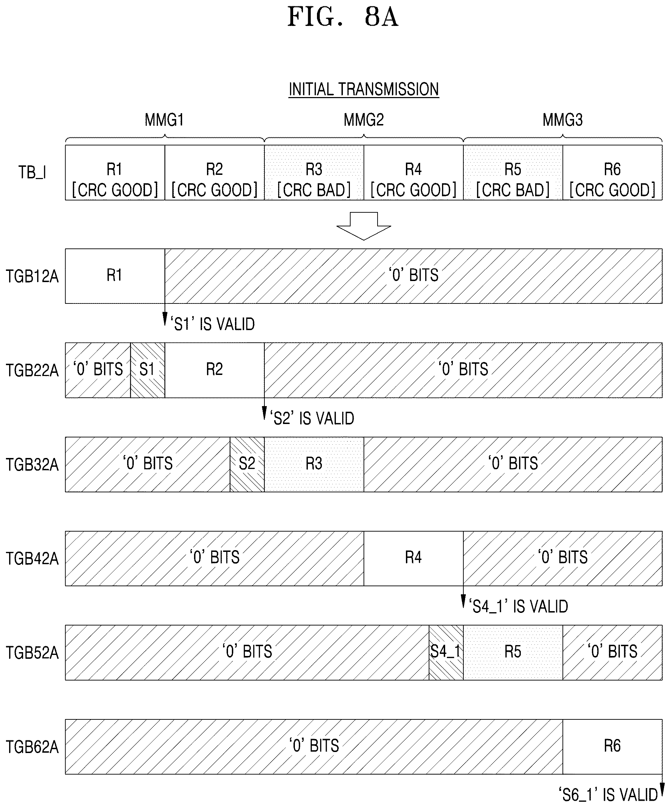

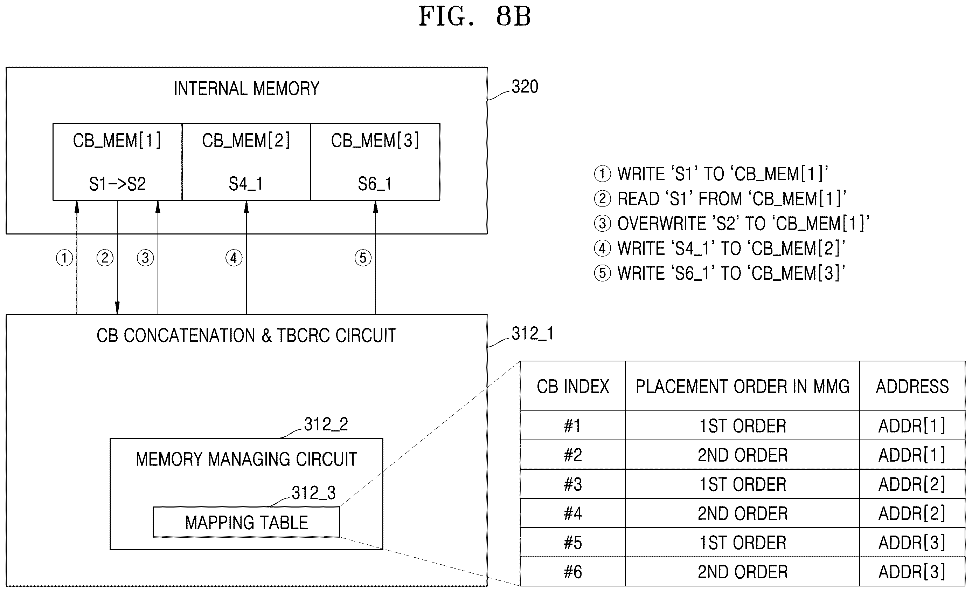

FIGS. 8A and 8B are diagrams for explaining a second CRC using the internal memory 320, according to an embodiment.

Referring to FIG. 8A, an initially-transmitted transport block TB_I may include first, second, third, fourth, fifth, and sixth code blocks R1, R2, R3, R4, R5, and R6, and the first through sixth code blocks R1 through R6 may be decoded into units of decoded code blocks by the decoding & CRC circuit 211_4 of FIG. 4 and may have completed a first CRC. The first, second, fourth, and sixth code blocks R1, R2, R4, and R6 may be determined as 'CRC GOOD' and thus may have passed the first CRC, and the third and fifth code block R3 and R5 may be determined as 'CRC BAD' and thus have failed the first CRC. Descriptions of FIGS. 8A and 8B that are the same as those of FIGS. 6A and 6B will now be omitted.

Referring further to FIG. 8B, the CB concatenation & TBCRC circuit 312_1 may generate a first target block TGB12A including the first code block R1 and zero bits. For example, the CB concatenation & TBCRC circuit 312_1 may place the first code block R1 at the same position as a position in the transport block TB_I, and fill the area after the first code block R1 with the zero bits to generate a first target block TGB12A.

The CB concatenation & TBCRC circuit 312_1 may divide the first target block TGB12A by a polynomial for the second CRC to generate a first remainder S1. Thereafter, the CB concatenation & TBCRC circuit 312_1 may determine, as valid data, the first remainder S1 corresponding to the first code block R1 that has passed the first CRC. The memory management circuit 312_2 may write the first remainder S1 to the first memory element CB_MEM[1], as in .

The memory management circuit 312_2 may read the first remainder S1 from the first memory element CB_MEM[1], as in (2), and the CB concatenation & TBCRC circuit 312_1 may generate a second target block TGB22A including the read-out first remainder S1, the second code block R2, and zero bits. For example, the CB concatenation & TBCRC circuit 312_1 may place the second code block R2 at the same position as a position in the transport block TB_I, place the first remainder S1 in front of the second code block R2, and fill the other portions of the transport block TB_1 with the zero bits to generate the second target block TGB22A.

The CB concatenation & TBCRC circuit 312_1 may divide the second target block TGB22A by a polynomial for the second CRC to generate a second remainder S2. Thereafter, the CB concatenation & TBCRC circuit 312_1 may determine, as valid data, the second remainder S2 corresponding to the second code block R2 that has passed the first CRC. The memory management circuit 312_2 may overwrite the second remainder S2 to the first memory element CB_MEM[1], as in ③. For example, the first remainder S1 previously written to the first memory element CB_MEM[1] is subsequently overwritten with the second remainder S2.

The CB connection & TBCRC circuit 312_1 may skip an operation on a third target block TGB32A corresponding to the third code block R3, based on the third code block R3 having failed the first CRC, and may then proceed with an operation on a fourth target block TGB42A corresponding to the fourth code block R4. Herein, an operation with respect to a target block may include at least one of an operation of generating the target block and an operation of dividing the generated target block by a polynomial for a second CRC to generate a remainder.

The CB concatenation & TBCRC circuit 312_1 may generate the fourth target block TGB42A including the fourth code block R4 and zero bits. For example, the CB concatenation & TBCRC circuit 312_1 may place the fourth code block R4 at the same position as a position in the transport block TB_I, and fill the other portions of the transport block TB_I with the zero bits to generate the fourth target block TGB42A.

The CB concatenation & TBCRC circuit 312_1 may divide the fourth target block TGB42A by a polynomial for the second CRC to generate a (4_1)th remainder S4_1. Thereafter, the CB concatenation & TBCRC circuit 312_1 may determine, as valid data, the (4_1)th remainder S4_1 corresponding to the fourth code block R4 that has passed the first CRC. The memory management circuit 312_2 may write the (4_1)th remainder S4_1 to the second memory element CB_MEM[2], as in ④. For example, the memory management circuit 312_2 may write the (4_1)th remainder S4_1 to the second memory element CB_MEM[2], based on the confirmation that the fourth code block R4 is mapped to the second arrangement order of the second memory management group MMG2 in the mapping table 312_3.

The CB connection & TBCRC circuit 312_1 may skip an operation on a fifth target block TGB52A corresponding to the fifth code block R5, based on the fifth code block R5 having failed the first CRC, and may then proceed with an operation on a sixth target block TGB62A corresponding to the sixth code block R6.

The CB concatenation & TBCRC circuit 312_1 may generate the sixth target block TGB62A including the sixth code block R6 and zero bits. For example, the CB concatenation & TBCRC circuit 312_1 may place the sixth code block R6 at the same position as a position in the transport block TB_I, and fill the other portions of the transport block TB_I with the zero bits to generate the sixth target block TGB62A.

The CB concatenation & TBCRC circuit 312_1 may divide the sixth target block TGB62A by a polynomial for the second CRC to generate a (6_1)th remainder S6_1. Thereafter, the CB concatenation & TBCRC circuit 312_1 may determine, as valid data, the (6_1)th remainder S6_1 corresponding to the sixth code block R6 that has passed the first CRC. The memory management circuit 312_2 may write the (6_1)th remainder S6_1 to the third memory element CB_MEM[3], as in ⑤. For example, the memory management circuit 312_2 may write the (6_1)th remainder S6_1 to the third memory element CB_MEM[3], based on the confirmation that the sixth code block R6 is mapped to the second arrangement order of the third memory management group MMG3 in the mapping table 312_3.

However, the operations ① through ⑤ disclosed in FIG. 8B are merely examples to help understanding of the embodiments, and thus the embodiments are not limited thereto. Some operations may be omitted or other operations may be added.

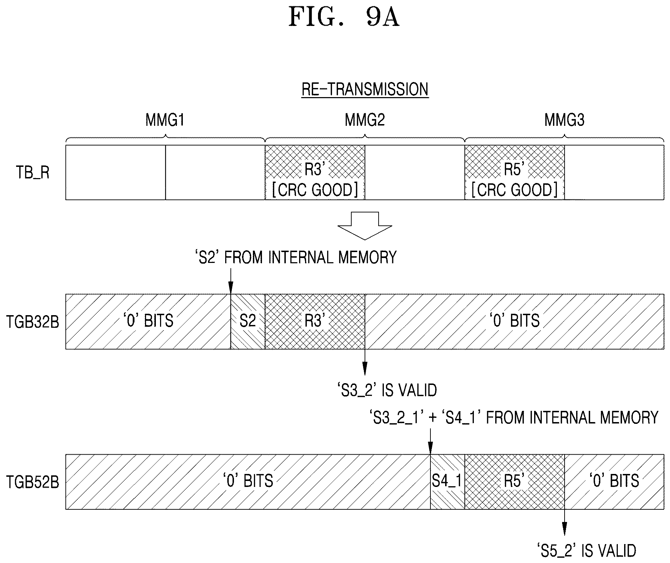

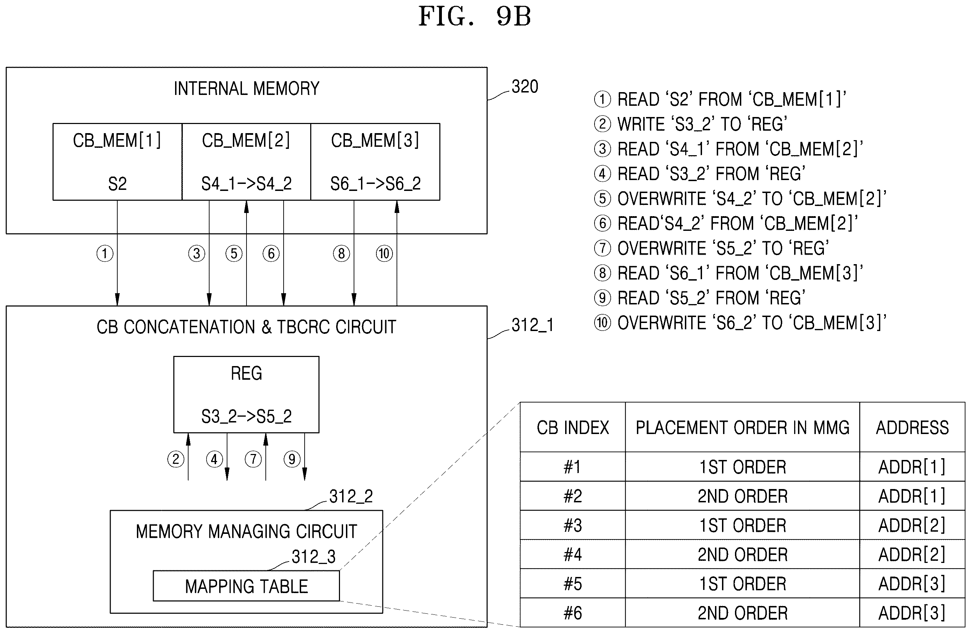

FIGS. 9A and 9B are diagrams for explaining a second CRC by a modem chip in detail, according to an embodiment. For example, FIGS. 9A and 9B may correspond to the second CRC described above with reference to FIGS. 8A and 8B.

Referring to FIG. 9A, a retransmitted transport block TB_R may include a retransmitted third code block R3' and a retransmitted fifth code block R5'. The aforementioned HARQ retransmission of an NR network is performed in units of code block groups. However, for convenience of description, the retransmitted third code block R3' and the retransmitted fifth code block R5' both used in the second CRC by the CB concatenation & TBCRC circuit 312_1 are focused on and illustrated in FIG. 9A. The retransmitted third code block R3' and the retransmitted fifth code block R5' may be decoded into units of decoded code blocks by the decoding & CRC circuit 211_4 of FIG. 4, and may be determined to be 'CRC GOOD' and thus have passed the first CRC.

Referring further to FIG. 9B, the memory management circuit 312_2 may read the second remainder S2 from the first memory element CB_MEM[1], as in ①, and the CB concatenation & TBCRC circuit 312_1 may generate a third' target block TGB32B including the read-out second remainder S2, the retransmitted third code block R3', and zero bits. For example, the CB concatenation & TBCRC circuit 312_1 may place the third code block R3' at the same position as a position in the transport block TB_R, place the second remainder S2 in front of the retransmitted third code block R3', and fill the other portions of the transport block TB_R with the zero bits to generate the third' target block TGB32B.

The CB concatenation & TBCRC circuit 312_1 may divide the third' target block TGB32B by a polynomial for the second CRC to generate a (3_2)th remainder S3_2. Thereafter, the CB concatenation & TBCRC circuit 312_1 may determine, as valid data, the (3_2)th remainder S3_2 corresponding to the retransmitted third code block R3' that has passed the first CRC. The register circuit of the CB concatenation & TBCRC circuit 312_1 may include a register REG. The memory management circuit 312_2 may write the (3_2)th remainder S3_2 to the register REG, as in ②. For example, the memory management circuit 312_2 may write the (3_2)th remainder S3_2 to the register REG, based on the confirmation that the third code block R3 is mapped to the first arrangement order of the second memory management group MMG2 in the mapping table 312_3.

The memory management circuit 312_2 may read the (4_1)th remainder S4_1 from the second memory element CB_MEM[2], as in ③, and may read the (3_2)th remainder S3_2 from the register REG, as in ④. The CB concatenation & TBCRC circuit 312_1 may sum the read-out (4_1)th remainder S4_1 with a (3_2_1)th remainder S3_2_1 generated from the read-out (3_2)th remainder S3_2, to thereby generate a (4_2)th remainder S4_2. For example, the (3_2_1)th remainder S3_2_1 may be generated by dividing, by a polynomial for the second CRC, data generated by attaching '0' bits, the number of which conforms to the number of code blocks (e.g., 1) between the retransmitted third code block R3' and the retransmitted fifth code block R5', to an end of the (3_2)th remainder S3_2. The memory management circuit 312_2 may overwrite the (4_2)th remainder S4_2 to the second memory element CB_MEM[2], as in ⑤. For example, the (3_2)th remainder S3_2 previously written to the register REG is subsequently overwritten with the (4_2)th remainder S4_2.

The memory management circuit 312_2 may read the (4_2)th remainder S4_2 from the second memory element CB_MEM[2], as in (6), and the CB concatenation & TBCRC circuit 312_1 may generate a fifth' target block TGB52B including the read-out (4_2)th remainder S4_2, the retransmitted fifth code block R5', and zero bits. For example, the CB concatenation & TBCRC circuit 312_1 may place the retransmitted fifth code block R5' at the same position as a position in the transport block TB_R, place the (4_2)th remainder S4_2 in front of the retransmitted fifth code block R5', and fill the other portions of the transport block TB_R with the zero bits to generate the fifth' target block TGB52B.

The CB concatenation & TBCRC circuit 312_1 may divide the fifth' target block TGB52B by a polynomial for the second CRC to generate a (5_2)th remainder S5_2. Thereafter, the CB concatenation & TBCRC circuit 312_1 may determine, as valid data, the (5_2)th remainder S5_2 corresponding to the retransmitted fifth code block R5' that has passed the first CRC. The memory management circuit 312_2 may overwrite the (5_2)th remainder S5_2 to the register REG, as in ⑦. For example, the (3_2)th remainder S3_2 previously written to the register REG is subsequently overwritten with the (5_2)th remainder S5_2.

The memory management circuit 312_2 may read the (6_1)th remainder S6_1 from the third memory element CB_MEM[3], as in ⑧, and may read the (5_2)th remainder S5_2 from the register REG, as in ⑨. The CB concatenation & TBCRC circuit 312_1 may divide, by a polynomial for the second CRC, data generated by summing the read-out (5_2)th remainder S5_2 with the read-out (6_1)th remainder S6_1, to thereby generate a (6_2)th remainder S6_2. The memory management circuit 312_2 may overwrite the (6_2)th remainder S6_2 to the third memory element CB_MEM[3], as in ⑩. For example, the (6_1)th remainder S6_1 previously written to the third memory element CB_MEM[3] is subsequently overwritten with the (6_2)th remainder S6_2.

The CB concatenation & TBCRC circuit 312_1 may determine whether the second CRC with respect to the decoded transport block has passed or failed, based on the (6_2)th remainder S6_2.

However, the operations ① through ⑩ disclosed in FIG. 9B are merely examples to help understanding of the embodiments, and thus the embodiments are not limited thereto. Some operations may be omitted or other operations may be added.

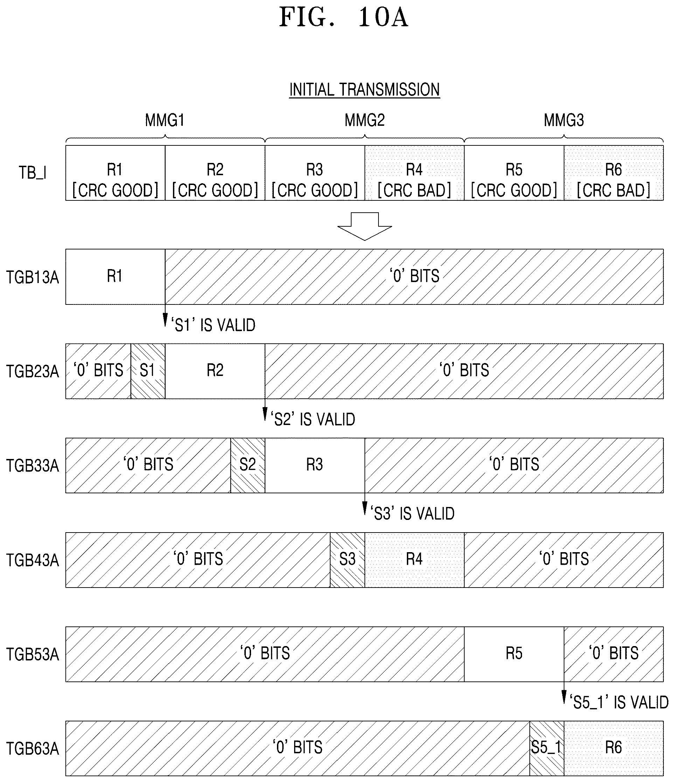

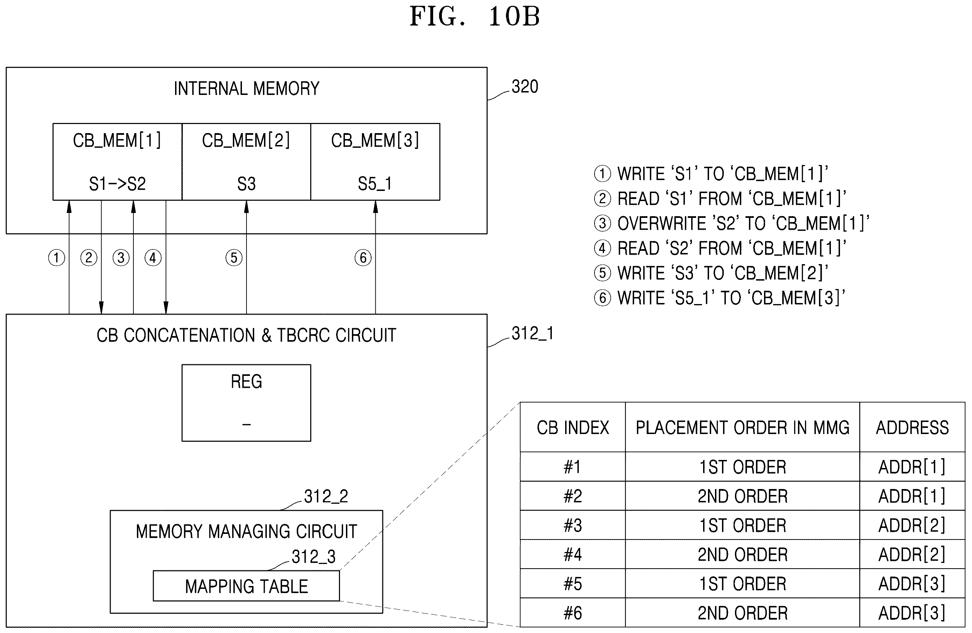

FIGS. 10A and 10B are diagrams for explaining a second CRC using the internal memory 320, according to an embodiment.

Referring to FIG. 10A, an initially-transmitted transport block TB_I may include first, second, third, fourth, fifth, and sixth code blocks R1, R2, R3, R4, R5, and R6, and the first through sixth code blocks R1 through R6 may be decoded into units of decoded code blocks by the decoding & CRC circuit 211_4 of FIG. 4 and may have completed a first CRC. The first, second, third, and fifth code blocks R1, R2, R3, and R5 may be determined as 'CRC GOOD' and thus may have passed the first CRC, and the fourth and sixth code block R4 and R6 may be determined as 'CRC BAD' and thus have failed the first CRC. Descriptions of FIGS. 10A and 10B that are the same as those of FIGS. 6A and 6B will now be omitted.

Referring further to FIG. 10B, the CB concatenation & TBCRC circuit 312_1 may generate a first target block TGB13A including the first code block R1 and zero bits. For example, the CB concatenation & TBCRC circuit 312_1 may place the first code block R1 at the same position as a position in the transport block TB_I, and fill the area after the first code block R1 with the zero bits to generate the first target block TGB13A.

The CB concatenation & TBCRC circuit 312_1 may divide the first target block TGB13A by a polynomial for the second CRC to generate a first remainder S1. Thereafter, the CB concatenation & TBCRC circuit 312_1 may determine, as valid data, the first remainder S1 corresponding to the first code block R1 that has passed the first CRC. The memory management circuit 312_2 may write the first remainder S1 to the first memory element CB_MEM[1], as in .

The memory management circuit 312_2 may read the first remainder S1 from the first memory element CB_MEM [1], as in (2), and the CB concatenation & TBCRC circuit 312_1 may generate a second target block TGB23A including the read-out first remainder S1, the second code block R2, and zero bits. For example, the CB concatenation & TBCRC circuit 312_1 may place the second code block R2 at the same position as a position in the transport block TB_I, place the first remainder S1 in front of the second code block R2, and fill the other portions of the transport block TB_I with the zero bits to generate the second target block TGB23A.

The CB concatenation & TBCRC circuit 312_1 may divide the second target block TGB23A by a polynomial for the second CRC to generate a second remainder S2. Thereafter, the CB concatenation & TBCRC circuit 312_1 may determine, as valid data, the second remainder S2 corresponding to the second code block R2 that has passed the first CRC. The memory management circuit 312_2 may overwrite the second remainder S2 to the first memory element CB_MEM[1], as in ③. For example, the first remainder S1 previously written to the first memory element CB_MEM[1] is subsequently overwritten with the second remainder S2.

The memory management circuit 312_2 may read the second remainder S2 from the first memory element CB_MEM[1], as in ④, and the CB concatenation & TBCRC circuit 312_1 may generate a third target block TGB33A including the read-out second remainder S2, the third code block R3, and zero bits. For example, the CB concatenation & TBCRC circuit 312_1 may place the third code block R3 at the same position as a position in the transport block TB_I, place the second remainder S2 in front of the third code block R3, and fill the other portions of the transport block TB_I with the zero bits to generate the third target block TGB33A.

The CB concatenation & TBCRC circuit 312_1 may divide the third target block TGB33A by a polynomial for the second CRC to generate a third remainder S3. Thereafter, the CB concatenation & TBCRC circuit 312_1 may determine, as valid data, the third remainder S3 corresponding to the third code block R3 that has passed the first CRC. The memory management circuit 312_2 may write the third remainder S3 to the second memory element CB_MEM[2], as in ⑤. For example, the memory management circuit 312_2 may write the third remainder S3 to the second memory element CB_MEM[2], based on the confirmation that the third code block R3 is mapped to the first arrangement order of the second memory management group MMG2 in the mapping table 312_3. Because a remainder corresponding to a fourth code block retransmitted later may be overwritten to the second memory element CB_MEM[2], the third remainder S3 may be written to the second memory element CB_MEM[2] instead of the register REG.

The CB connection & TBCRC circuit 312_1 may skip an operation on a fourth target block TGB43A corresponding to the fourth code block R4, based on the fourth code block R4 having failed the first CRC, and then may proceed with an operation on a fifth target block TGB53A corresponding to the fifth code block R5.

The CB concatenation & TBCRC circuit 312_1 may generate the fifth target block TGB53A including the fifth code block R5 and zero bits. For example, the CB concatenation & TBCRC circuit 312_1 may place the fifth code block R5 at the same position as a position in the transport block TB_I, and fill the other portions of the transport block TB_I with the zero bits to generate the fifth target block TGB53A.

The CB concatenation & TBCRC circuit 312_1 may divide the fifth target block TGB53A by a polynomial for the second CRC to generate a (5_1)th remainder S5_1. Thereafter, the CB concatenation & TBCRC circuit 312_1 may determine, as valid data, the (5_1)th remainder S5_1 corresponding to the fifth code block R5 that has passed the first CRC. The memory management circuit 312_2 may write the (5_1)th remainder S5_1 to the third memory element CB_MEM[3], as in ⑥. For example, the memory management circuit 312_2 may write the (5_1)th remainder S5_1 to the third memory element CB_MEM[3], based on the confirmation that the fifth code block R5 is mapped to the first arrangement order of the third memory management group MMG3 in the mapping table 312_3. Because a remainder corresponding to a sixth code block retransmitted later may be overwritten to the third memory element CB_MEM[3], the (5_1)th remainder S5_1 may be written to the third memory element CB_MEM[3] instead of the register REG.

The CB connection & TBCRC circuit 312_1 may skip an operation on a sixth target block TGB63A corresponding to the sixth code block R6, based on the sixth code block R6 having failed the first CRC.

However, the operations ① through ⑥ disclosed in FIG. 10B are merely examples to help understanding of the embodiments, and thus the embodiments are not limited thereto. Some operations may be omitted or other operations may be added.

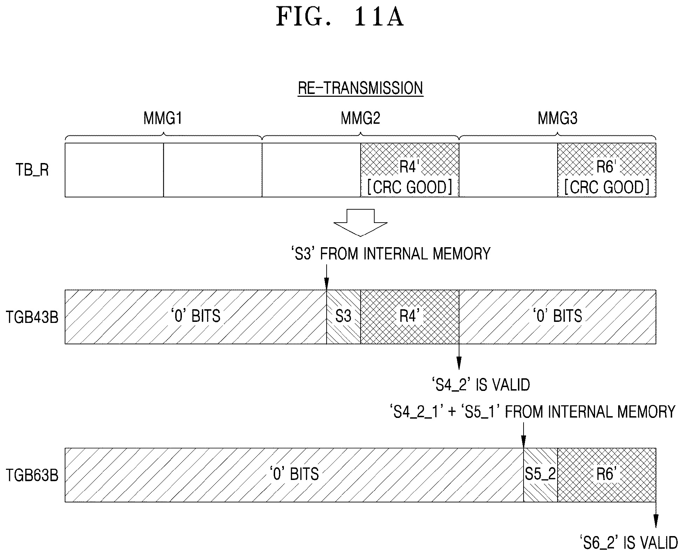

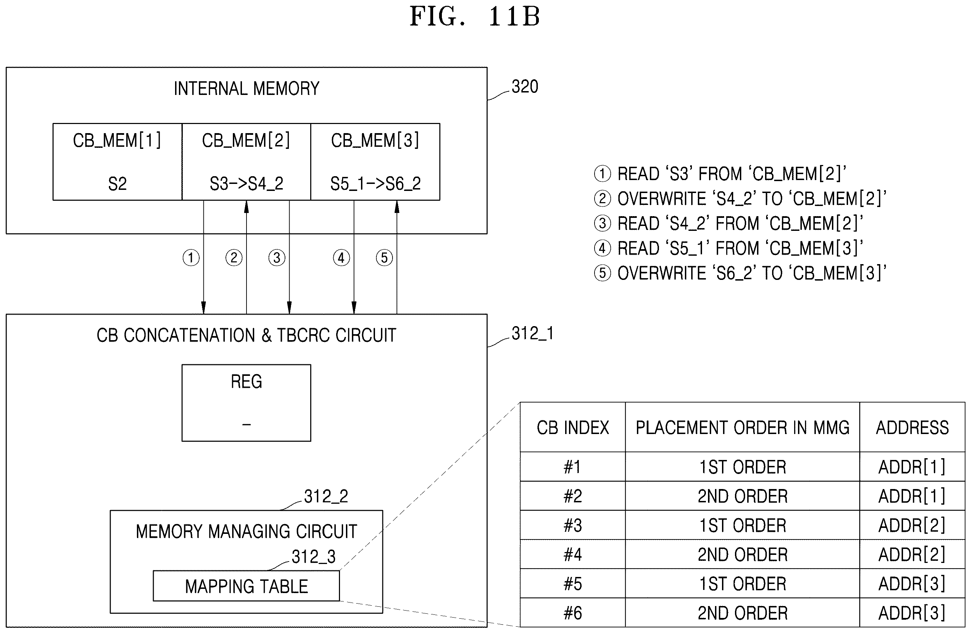

FIGS. 11A and 11B are diagrams for explaining a second CRC by a modem chip in detail, according to an embodiment. FIGS. 11A and 11B may correspond the second CRC described above with reference to FIGS. 10A and 10B.

Referring to FIG. 11A, a retransmitted transmission block TB_R may include a retransmitted fourth code block R4' and a retransmitted sixth code block R6'. The aforementioned HARQ retransmission of an NR network is performed in units of code block groups. However, for convenience of description, the retransmitted fourth code block R4' and the retransmitted sixth code block R6' both used in the second CRC by the CB concatenation & TBCRC circuit 312_1 are focused on and illustrated in FIG. 11A. The retransmitted fourth code block R4' and the retransmitted sixth code block R6' may be decoded into units of decoded code blocks by the decoding & CRC circuit 211_4 of FIG. 4, and may be determined to be 'CRC GOOD' and thus have passed the first CRC.

The memory management circuit 312_2 may read the third remainder S3 from the second memory element CB_MEM[2], as in ①, and the CB concatenation & TBCRC circuit 312_1 may generate a fourth' target block TGB43B including the read-out third remainder S3, the retransmitted fourth code block R4', and zero bits. For example, the CB concatenation & TBCRC circuit 312_1 may place the retransmitted fourth code block R4' at the same position as a position in the transport block TB_R, place the third remainder S3 in front of the retransmitted fourth code block R4', and fill the other portions of the transport block TB_R with the zero bits to generate the fourth' target block TGB43B.

The CB concatenation & TBCRC circuit 312_1 may divide the fourth' target block TGB43B by a polynomial for the second CRC to generate a (4_2)th remainder S4_2. Thereafter, the CB concatenation & TBCRC circuit 312_1 may determine, as valid data, the (4_2)th remainder S4_2 corresponding to the retransmitted fourth code block R4' that has passed the first CRC. The memory management circuit 312_2 may overwrite the (4_2)th remainder S4_2 to the second memory element CB_MEM[2], as in . For example, the third remainder S3 previously written to the second memory element CB_MEM[2] is subsequently overwritten with the (4_2)th remainder S4_2. The memory management circuit 312_2 may overwrite the (4_2)th remainder S4_2 to the second memory element CB_MEM[2], based on the confirmation that the fourth code block R4 is mapped to the second arrangement order of the second memory management group MMG2 in the mapping table 312_3.

The memory management circuit 312_2 may read the (4_2)th remainder S4_2 from the second memory element CB_MEM[2], as in ③, and may read a (5_1)th remainder S5_1 from the third memory element CB_MEM[3], as in ④. The CB concatenation & TBCRC circuit 312_1 may sum the read-out (5_1)th remainder S5_1 with a (4_2_1)th remainder S4_2_1 generated from the read-out (4_2)th remainder S4_2, to thereby generate a (5_2)th remainder S5_2. For example, the (4_2_1)th remainder S4_2_1 may be generated by dividing, by a polynomial for the second CRC, data generated by attaching '0' bits, the number of which conforms to the number of code blocks (e.g., 1) between the retransmitted fourth code block R4' and the retransmitted sixth code block R6', to an end of the (4_2)th remainder S4_2. The CB concatenation & TBCRC circuit 312_1 may generate a sixth' target block TGB63B including the generated 5_2 remainder S5_2, the retransmitted sixth code block R6', and zero bits. For example, the CB concatenation & TBCRC circuit 312_1 may place the retransmitted sixth code block R6' at the same position as a position in the transport block TB_R, place the (5_2)th remainder S5_2 in front of the retransmitted sixth code block R6', and fill the other portions of the transport block TB_R with the zero bits to generate the sixth' target block TGB63B.

The CB concatenation & TBCRC circuit 312_1 may divide the sixth' target block TGB63B by a polynomial for the second CRC to generate a (6_2)th remainder S6_2. Thereafter, the CB concatenation & TBCRC circuit 312_1 may determine, as valid data, the (6_2)th remainder S6_2 corresponding to the retransmitted sixth code block R6' that has passed the first CRC. The memory management circuit 312_2 may overwrite the (6_2)th remainder S6_2 to the third memory element CB_MEM[3], as in ⑤. For example, the (5_1)th remainder S5_1 previously written to the third memory element CB_MEM[3] is subsequently overwritten with the (6_2)th remainder S6_2. The memory management circuit 312_2 may overwrite the (6_2)th remainder S6_2 to the third memory element CB_MEM[3], based on the confirmation that the sixth code block R6 is mapped to the second arrangement order of the third memory management group MMG3 in the mapping table 312_3.

The CB concatenation & TBCRC circuit 312_1 may determine whether the second CRC with respect to the decoded transport block has passed or failed, based on the (6_2)th remainder S6_2.

According to some embodiments, the (5_2)th remainder S5_2 may be written to the third memory element CB_MEM[3] to be read to generate the sixth' target block TGB63B, and then the (6_2)th remainder S6_2 may be erased while being overwritten to the third memory element CB_MEM[3].

However, the operations ① through ⑤ disclosed in FIG. 11B are merely examples to help understanding of the embodiments, and thus the embodiments are not limited thereto. Some operations may be omitted or other operations may be added.

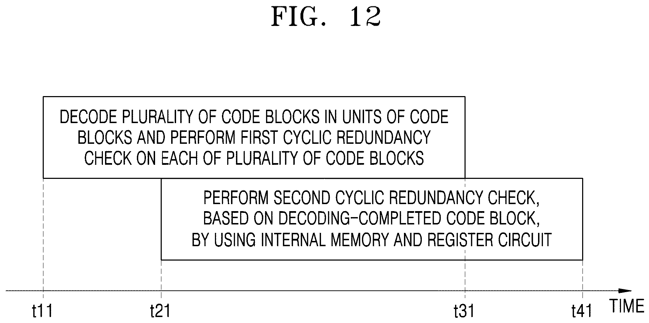

FIG. 12 is a diagram for explaining a relationship between a time period in which a first CRC is performed and time period in which a second CRC is performed, according to an embodiment.

Referring to FIG. 12, a modem chip may perform code block-by-code block decoding and code block-by-code block first CRC with respect to the code blocks of a received codeword, between a first time t11 (e.g., first time point) and a third time t31 (e.g., third time point).

The modem chip may also perform a second CRC on a decoded transport block based on a decoding-completed code block, by using an internal memory and a register circuit, between a second time t21 (e.g., second time point) and a fourth time t41 (e.g., fourth time point). For example, the modem chip may partially perform the second CRC by generating a target block, based on the decoding-completed code block, and performing a modular arithmetic of dividing the target block by a polynomial for the second CRC. The modem chip may perform the second CRC, and may store sequentially-generated intermediate data in any one of the internal memory and the register circuit, based on memory management information.

As in FIG. 12, a time period in which decoding of each code block and a first CRC with respect to each code block are performed by the modem chip may overlap with a time period in which the second CRC is performed by the modem chip, between the second time t21 and the third time t31.

For example, the modem chip may partially perform the second CRC by immediately using a decoded code block each time decoding of a code block is completed, without waiting for completion of the decoding and the first CRC with respect to subsequent code blocks in a received codeword, and the internal memory and the register circuit may provide a storage space for a second CRC.

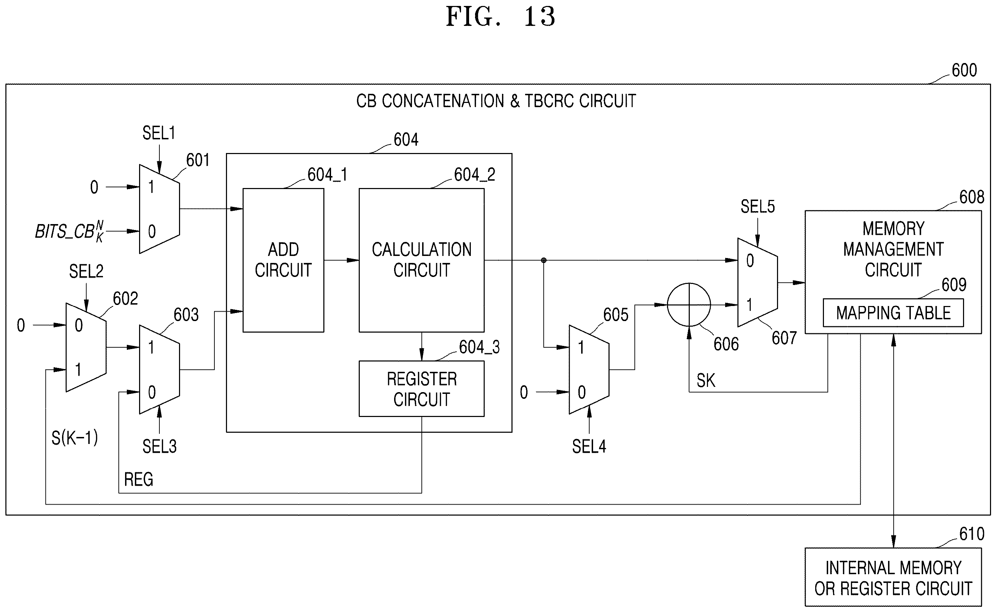

FIG. 13 is a block diagram of a CB concatenation & TBCRC circuit 600 according to an embodiment.

Referring to FIG. 13, the CB concatenation & TBCRC circuit 600 may include first, second, third, fourth, and fifth multiplexers 601, 602, 603, 605, and 607, a TBCRC circuit 604, an adder 606, and a memory management circuit 608. The TBCRC circuit 604, which is a circuit that performs a second CRC, may include an add circuit 604_1, a calculation circuit 604_2, and a register 604_3. $CB_K^N$ may be an input indicating whether a K-th (where K is an integer greater than or equal to 1) code block of an N-th (where N is an integer greater than or equal to 1) transmitted codeword has passed the first CRC after being decoded. For example, when $CB_K^N$ is '1', it may indicate that the first CRC has passed, and, when $CB_K^N$ is '0', it may indicate that the first CRC has failed. When a K-th code block of an (N-1)th transmitted codeword has passed the first CRC, $CB_K^{N-1}$ may be '1'. An arithmetic operation for obtaining a remainder of a target block corresponding to the K-th code block of the N-th transmitted codeword may be based on $CB_K^{N-1}$ corresponding to the K-th code block of the (N-1)th transmitted codeword, $CB_{K+1}^{N-1}$ corresponding to a (K+1)th code block of the (N-1)th transmitted codeword, $C_{K-1}^N$ corresponding to a (K-1)th code block of the N-th transmitted codeword, and $CB_K^N$ corresponding to the K-th code block of the N-th transmitted codeword.

The first multiplexer 601 may output either $BITS\_CB_K^N$ or '0' based on a first selection signal SEL1 corresponding to $CB_K^{N-1}$ to the add circuit 604_1. $BITS\_CB_K^N$ may indicate decoded bits included in the K-th code block of the N-th transmitted codeword.

The second multiplexer 602 may output, to the third multiplexer 603, one of 'S(K-1)' and '0' based on a second selection signal SEL2 corresponding to $CB_{K-1}^N$. 'S(K-1)' may indicate a remainder corresponding to the (K-1)th code block of the N-th transmitted codeword.

The third multiplexer 603 may output, to the add circuit 604_1, one of an output of the third multiplexer 602 and a register value REG based on a third selection signal SEL3 corresponding to $CB_K^{N-1}$.

The add circuit 604_1 may add (e.g., concatenate) an output of the third multiplexer 603 to the output of the first multiplexer 601. For example, when the output of the first multiplexer 601 is '111111', the add circuit 604_1 may add (e.g., concatenate) '010', which is the output of the third multiplexer 603, to the front of '111111' to generate '010 111111'. The add circuit 604_1 may further add (e.g., concatenate) zero bits to the data '010111111' generated based on the output of the first multiplexer 601 and the output of the third multiplexer 603. For example, the add circuit 604_1 may generate a target block corresponding to the K-th code block of the N-th transmitted codeword.

The calculation circuit 604_2 may perform a modular arithmetic on the target block provided by the add circuit 604_1. The calculation circuit 604_2 may store a remainder corresponding to the target block, which is a result of the modular arithmetic, in the register 604_3, or may output the same as inputs of the fourth and fifth multiplexers 605 and 607.

The fourth multiplexer 605 may output either the result of the modular arithmetic provided by the calculation circuit 604_2 or '0' to the adder 606, based on a fourth selection signal SEL4. For example, a value of the fourth selection signal SEL4 may be set based on whether an update of the remainder corresponding to the K-th code block is needed.

The adder 606 may add the output of the fourth multiplexer 605 to 'SK' and output a result of the addition. 'SK' may indicate a remainder corresponding to the K-th code block of the N-th transmitted codeword.

The fifth multiplexer 607 may output either a result of the modular arithmetic provided by the calculation circuit 604_2 or the output of the adder 606, based on a fifth selection signal SEL5. For example, a value of the fifth selection signal SEL5 may be set based on whether decoding of the K-th and (K-1)th code blocks of the (N-1)th transmitted codeword has been successful.

The memory management circuit 608 may store data generated by the CB concatenation & TBCRC circuit 600 in an internal memory or register circuit 610, based on a mapping table 609 including information about a memory management group. For example, the memory management circuit 608 may store the output of the fourth multiplexer 605 in the internal memory or register circuit 610, based on the mapping table 609. The memory management circuit 608 may read 'S(K-1)' and 'SK' from the internal memory or register circuit 610, based on the mapping table 609.

However, FIG. 13 is merely an example embodiment, and thus the embodiments are not limited thereto. Various CB concatenation & TBCRC circuits 600 may be implemented so as to perform a second CRC according to the embodiments.

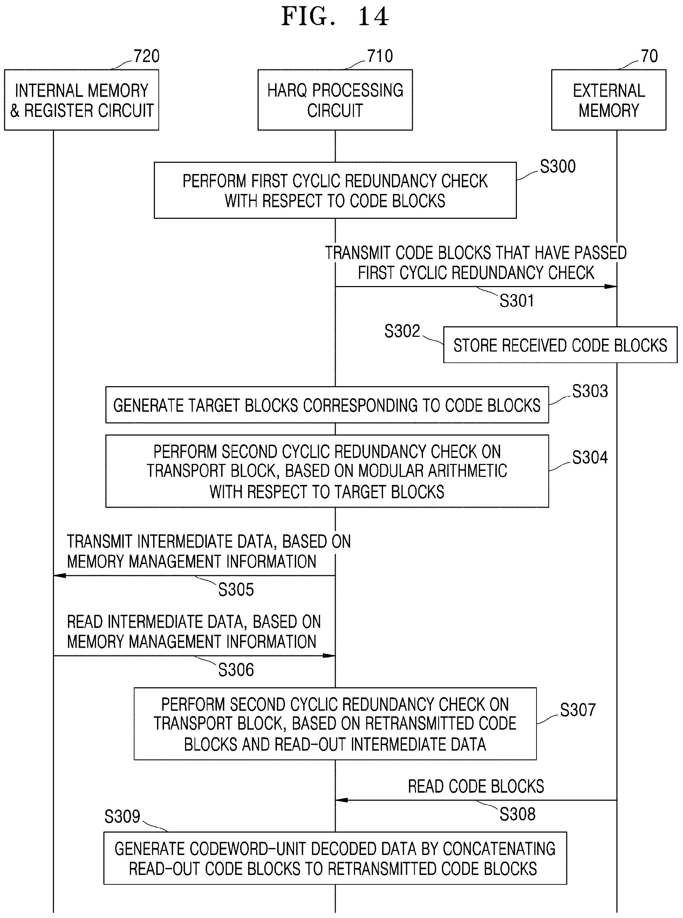

FIG. 14 is a flowchart of an operation method of a HARQ processing circuit 710 according to an embodiment. The HARQ processing circuit 710 is a component included in a modem chip, together with an internal memory or register circuit 720, and an operation of the HARQ processing circuit 710 may be understood as an operation of the modem chip. In FIG. 14, it is assumed that both code blocks and a transport block are in a decoded state and there are code blocks that need retransmission among the code blocks.

Referring to FIG. 14, in operation S300, the HARQ processing circuit 710 may perform a first CRC with respect to the code blocks.

In operation S301, the HARQ processing circuit 710 may transmit, to an external memory 70, code blocks that have passed the first CRC.

In operation S302, the external memory 70 may store the code blocks received from the HARQ processing circuit 710.

In operation S303, the HARQ processing circuit 710 may generate target blocks corresponding to the code blocks.

In operation S304, the HARQ processing circuit 710 may perform a second CRC on the transport block, based on a modular arithmetic with respect to the target blocks.

In operation S305, the HARQ processing circuit 710 may store intermediate data in the internal memory or register circuit 720, based on memory management information including information about a memory management group.

In operation S306, the HARQ processing circuit 710 may read the intermediate data from the internal memory or register circuit 720, based on the memory management information.

In operation S307, the HARQ processing circuit 710 may perform a second CRC on the transport block, based on the retransmitted target blocks that have passed the first CRC and the read-out intermediate data.

In operation S308, the HARQ processing circuit 710 may read code blocks from the external memory 70, when the second CRC has passed.

In operation S309, the HARQ processing circuit 710 may generate codeword-unit decoded data by concatenating the read-out code blocks to the retransmitted code blocks.

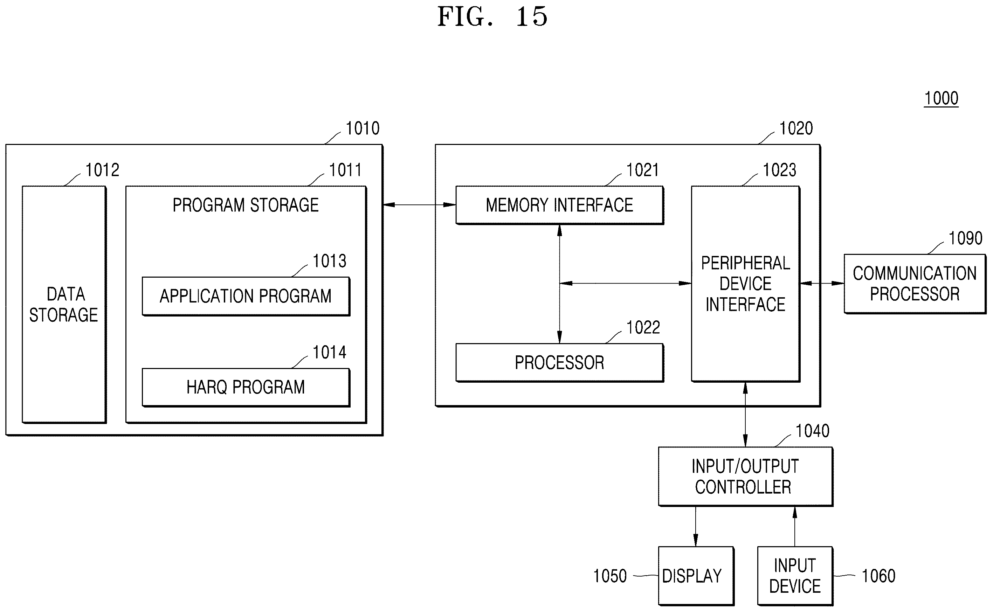

FIG. 15 is a block diagram of an electronic device 1000 according to an embodiment.

Referring to FIG. 15, the electronic device 1000 may include a memory 1010, a processor unit 1020, an input/output controller 1040, a display 1050, an input device 1060, and a communication processor 1090. There may be a plurality of memories 1010. Each element will be described below.

The memory 1010 may include a program storage 1011, which stores a program for controlling an operation of the electronic device 1000, and a data storage 1012, which stores data generated during execution of the program. The data storage 1012 may store data necessary for respective operations of an application program 1013 and a HARQ program 1014.

The program storage 1011 may include the application program 1013 and the HARQ program 1014. A program included in the program storage 1011 is a set of instructions, and may be expressed as an instruction set. The application program 1013 may include program code for executing various applications run by the electronic device 1000. For example, the application program 1013 may include code (or commands) related to various applications run by a processor 1022. The HARQ program 1014 may include commands for performing a decoding of code blocks received in a codeword, performing a first CRC on the decoded code blocks, and performing a second CRC on target blocks (i.e., decoded code blocks that have passed the first CRC), according to embodiments of the inventive concept.

According to an embodiment, the processor 1022 may execute the second CRC program 1014 to sequentially generate target blocks from the code blocks and perform a second CRC on a transport block, based on a modular arithmetic with respect to the target blocks. The processor unit 1020 may include an internal memory, and the processor 1022 may store intermediate data generated during the second CRC, in the internal memory, based on the memory management information.

The communication processor 1090 of the electronic device 1000 may perform communication functions for voice communication and data communication. A peripheral device interface 1023 may control connection among the input/output controller 1040, the communication processor 1090, the processor 1022, and a memory interface 1021.

The input/output controller 1040 may provide an interface between an input/output device, such as the display 1050 or the input device 1060, and the peripheral device interface 1023. The display 1050 displays status information, input text, a moving picture, and a still picture, for example. For example, the display 1050 may display information about an application program run by the processor 1022.

The input device 1060 may provide input data, which is generated by the selection of the electronic device 1000, to the processor unit 1020 through the input/output controller 1040. In this case, the input device 1060 may include, for example, a keypad, which includes at least one hardware button, and a touch pad sensing touch information. For example, the input device 1060 may provide touch information, such as a touch, a movement of the touch, or the release of the touch, which is detected through a touch pad, to the processor 1022 through the input/output controller 1040.

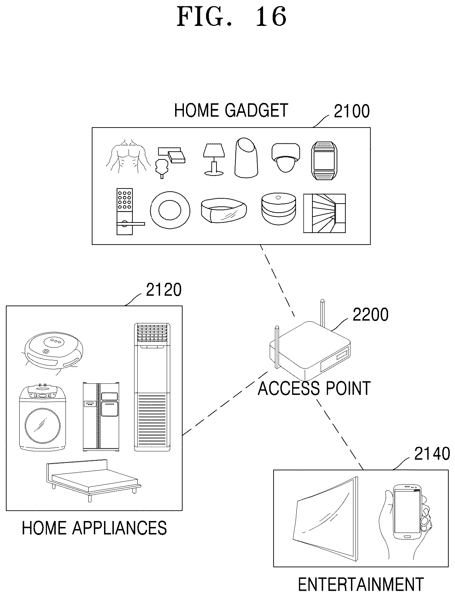

FIG. 16 is a view illustrating communication apparatuses configured to perform a second CRC according to an embodiment.

Referring to FIG. 16, a modem included in a home gadget 2100, home appliances 2120, an entertainment device 2140, and an access point (AP) 2200 may perform a second CRC according to embodiments. The modem may efficiently utilize its internal memory when performing a second CRC.

According to some embodiments, the home gadget 2100, the home appliances 2120, the entertainment device 2140, and the AP 2200 may constitute an Internet of Things (IoT) network system. The communication devices illustrated in FIG. 16 are merely examples, and it will be understood that other communication devices not illustrated in FIG. 16 may also include a wireless communication device according to an embodiment.

As used herein, numbers are used as labels to distinguish certain elements, values or signals. Such terms as "1st" and "2nd", or "first" and "second" may be used to simply distinguish a corresponding feature from another, and do not necessary limit the components in other aspect (e.g., importance or order). Similarly, labels such as "(3_1)th", "(3_2)th", "(3_1_1)th", "(3_1_2)th", etc. are used to distinguish a corresponding feature from another, and do not limit the components in other aspect (e.g., importance or order). It will be appreciated that any of these labels may be replaced with other labels (e.g., other numerical labels in different formats or orders).

Aspects of the inventive concept have been particularly shown and described with reference to embodiments thereof. The terminology used herein is for the purpose of describing embodiments only and is not intended to be limiting. Therefore, it will be understood by those skilled in the art that various changes in form and details may be made therein without departing from the scope of the inventive concept as defined by the appended claims.

**Claims**

1. A modem chip capable of receiving a codeword including a transport block including a plurality of code blocks, the modem chip comprising:

   a hybrid automatic repeat request, HARQ, processing circuit (110) configured to perform a HARQ-based processing operation including a first cyclic redundancy check and a second cyclic redundancy check with respect to the codeword; and
   an internal memory (120) configured to store data generated during the second cyclic redundancy check, wherein
   the HARQ processing circuit (110) comprises:

   a code block processing circuit (111) configured to decode the plurality of code blocks into decoded code blocks and perform the first cyclic redundancy check on each of the decoded code blocks; and
   a codeword processing circuit (112) configured to perform the second cyclic redundancy check on a decoded transport block by generating target blocks corresponding to the decoded code blocks based on modular arithmetic using a polynomial for the second cyclic redundancy check,

   the plurality of code blocks are classified into a plurality of memory management groups each including at least two code blocks, and
   the internal memory (120) includes a plurality of memory elements allocated to the plurality of memory management groups in a one-to-one correspondence.

2. The modem chip of claim 1, wherein each of the plurality of memory elements is configured to have a capacity corresponding to a data size of a remainder generated by the modular arithmetic with respect to one target block.

3. The modem chip of claim 1 or claim 2, wherein

   a first memory management group among the plurality of memory management groups includes a first code block and a second code block arranged sequentially,
   a first memory element among the plurality of memory elements is allocated to the first memory management group,
   the codeword processing circuit (112) is further configured to access the first memory element, based on results of the first cyclic redundancy check with respect to a decoded first code block and a decoded second code block included in the decoded code blocks, and memory management information corresponding to the first memory management group, during a time period when the second cyclic redundancy check is performed, and
   the memory management information includes an arrangement order between the first code block and the second code block and an address of the first memory element.

4. The modem chip of claim 3, wherein the codeword processing circuit (112) is configured to write, to the first memory element, a first remainder generated by the modular arithmetic with respect to a first target block included in the target blocks, the first target block corresponding to the decoded first code block that has passed the first cyclic redundancy check, and to overwrite to the first memory element, a second remainder generated by the modular arithmetic with respect to a second target block included in the target blocks, the second target block corresponding to the decoded second code block that has passed the first cyclic redundancy check.

5. The modem chip of claim 3, wherein the codeword processing circuit (112) is further configured to write, to the first memory element, a first remainder generated by the modular arithmetic with respect to a first target block included in the target blocks, the first target block corresponding to the decoded first code block that has passed the first cyclic redundancy check, and to skip writing a second remainder generated by the modular arithmetic with respect to a second target block included in the target blocks, the second target block corresponding to the decoded second code block that has failed the first cyclic redundancy check.

6.  The modem chip of claim 5, wherein

    the modem chip is configured to receive a retransmitted second code block, and
    the codeword processing circuit (112) is further configured to overwrite, to the first memory element, a third remainder generated by the modular arithmetic with respect to a third target block included in the target blocks, the third target block corresponds to the retransmitted second code block which passes the first cyclic redundancy check.

7.  The modem chip of claims 3-6, further comprising a register circuit including a first register,
    wherein the codeword processing circuit (112) is configured to selectively access the first register based on the result of the first cyclic redundancy check and the memory management information during the time period when the second cyclic redundancy check is performed.

8.  The modem chip of claim 7 when dependent on claim 3, wherein the codeword processing circuit (112) is configured to skip writing a first remainder generated by the modular arithmetic with respect to a first target block included in the target blocks, the first target block corresponding to the decoded first code block that has failed the first cyclic redundancy check and to write, to the first memory element, a second remainder generated by the modular arithmetic with respect to a second target block included in the target blocks, the second target block corresponding to the decoded second code block that has passed the second cyclic redundancy check.

9.  The modem chip of claim 8, wherein

    the modem chip further receives a retransmitted first code block, and
    the codeword processing circuit (112) is further configured to write, to the first register, third intermediate data generated by the modular arithmetic with respect to a third target block included in the target blocks, the third target block corresponding to the retransmitted first code block which passes the first cyclic redundancy check.

10. The modem chip of any of claims 7-9, wherein a storage capacity of the internal memory (120) is greater than the register circuit.

11. The modem chip of any of claims 1-3 or 8-10, wherein the code block processing circuit (111) is further configured to store, in an external memory (11), a decoded second code block that has passed the first cyclic redundancy check from among the decoded code blocks, based on a decoded first code block among the decoded code blocks having failed the first cyclic redundancy check.

12. The modem chip of claim 11, wherein,

    the internal memory (120) is configured to be dedicated to the modem chip, and
    the external memory (11) is configured to be shared with an external device.

13. The modem chip of any preceding claim, wherein a memory management group unit in the plurality of memory management groups corresponds to a code block group that includes a plurality of code blocks that are retransmitted together.

14. The modem chip of any preceding claim, wherein the codeword processing circuit (112) is further configured to determine whether the second cyclic redundancy check has passed, based on a final remainder corresponding to the last target block among the target blocks.

15. The modem chip of any preceding claim, wherein

    the decoded code blocks include a first code block, a second code block, and a third code block sequentially processed by the code block processing circuit (111), and
    the target blocks comprise:

        a first target block including the first code block and zero bits;

a second target block including the second code block, zero bits, and a first remainder obtained by dividing the first target block by the polynomial; and

a third target block including the third code block, zero bits, and a second remainder obtained by dividing the second target block by the polynomial.

# FIG. 1

MODEM 100

HARQ PROCESSING CIRCUIT 110

CODE BLOCK PROCESSING CIRCUIT 111

CODEWORD PROCESSING CIRCUIT 112

INTERNAL MEMORY 120

EXTERNAL MEMORY 11

HOST DEVICE 12

# FIG. 2

EP 4 738 736 A1

CW

TB

CB1 | CB2 | CB3 | CB4 | ··· | CB(X−1) | CBX

CBG1

CBG2

CBG(X/2)

: TBCRC BITS

: CRC BITS

# FIG. 3

```
      220                      210                          20
┌──────────────┐      ┌──────────────────┐        ┌──────────────┐
│   INTERNAL   │      │ HARQ PROCESSING  │        │   EXTERNAL   │
│    MEMORY    │      │     CIRCUIT      │        │    MEMORY    │
└──────────────┘      └──────────────────┘        └──────────────┘
       │                       │                         │
       │                       │         S100            │
       │             ┌─────────────────────────────────────────┐
       │             │ STORE, IN EXTERNAL MEMORY, DECODED CODE  │
       │             │ BLOCKS THAT HAVE PASSED FIRST CYCLIC     │
       │             │ REDUNDANCY CHECK FROM AMONG CODE         │
       │             │ BLOCKS INCLUDED IN TRANSPORT BLOCK       │
       │             └─────────────────────────────────────────┘
       │      S110             │                         │
┌─────────────────────────────────────────┐             │
│ PERFORM SECOND CYCLIC REDUNDANCY         │             │
│ CHECK ON DECODED TRANSPORT BLOCK BY      │             │
│ USING INTERNAL MEMORY                    │             │
└─────────────────────────────────────────┘             │
       │                       │         S120            │
       │             ┌─────────────────────────────────────────┐
       │             │ GENERATE DECODED TRANSPORT BLOCK,        │
       │             │ BASED ON DECODED CODE BLOCKS             │
       │             │ STORED IN EXTERNAL MEMORY AND            │
       │             │ RETRANSMITTED AND DECODED CODE BLOCK     │
       │             └─────────────────────────────────────────┘
       │                       │                         │
```

## FIG. 4

EP 4 738 736 A1

# FIG. 5A

212_1A

**CB CONCATENATION & TBCRC CIRCUIT**

MEMORY MANAGING CIRCUIT — 212_2A

MAPPING TABLE — 212_3A

REGISTER CIRCUIT — 212_4A

220A

**INTERNAL MEMORY**

| CB_MEM[1] | CB_MEM[2] | ... | CB_MEM[X/2] |

MMG1          MMG2                    MMG(X/2)

| CB1 | CB2 | CB3 | CB4 | ... | CB(X-1) | CBX |

# FIG. 5B

CB CONCATENATION & TBCRC CIRCUIT — 212_1B

MEMORY MANAGING CIRCUIT — 212_2B

MAPPING TABLE — 212_3B

REGISTER CIRCUIT — 212_4B

INTERNAL MEMORY — 220B

CB_MEM[1] | CB_MEM[2] | ⋯ | CB_MEM[Y]

MMG1 | MMG2 | MMGY

CBG1 | CBG2 | ⋯ | CBGY

EP 4 738 736 A1

# FIG. 6A

# FIG. 6B

INTERNAL MEMORY — 320

| CB_MEM[1] | CB_MEM[2] | CB_MEM[3] |
|:---:|:---:|:---:|
| S1->S2 | S3->S4 | S5->S6 |

① ② ③ ④ ⑤ ⑥ ⑦ ⑧ ⑨ ⑩ ⑪

CB CONCATENATION & TBCRC CIRCUIT — 312_1

MEMORY MANAGING CIRCUIT — 312_2

MAPPING TABLE — 312_3

① WRITE 'S1' TO 'CB_MEM[1]'
② READ 'S1' FROM 'CB_MEM[1]'
③ OVERWRITE 'S2' TO 'CB_MEM[1]'
④ READ 'S2' FROM 'CB_MEM[1]'
⑤ WRITE 'S3' TO 'CB_MEM[2]'
⑥ READ 'S3' FROM 'CB_MEM[2]'
⑦ OVERWRITE 'S4' TO 'CB_MEM[2]'
⑧ READ 'S4' FROM 'CB_MEM[2]'
⑨ WRITE 'S5' TO 'CB_MEM[3]'
⑩ READ 'S5' FROM 'CB_MEM[3]'
⑪ OVERWRITE 'S6' TO 'CB_MEM[3]'

| CB INDEX | PLACEMENT ORDER IN MMG | ADDRESS |
|:---:|:---:|:---:|
| #1 | 1ST ORDER | ADDR[1] |
| #2 | 2ND ORDER | ADDR[1] |
| #3 | 1ST ORDER | ADDR[2] |
| #4 | 2ND ORDER | ADDR[2] |
| #5 | 1ST ORDER | ADDR[3] |
| #6 | 2ND ORDER | ADDR[3] |

EP 4 738 736 A1

# FIG. 7

START

↓

PERFORM DECODING ON RETRANSMITTED CODE BLOCK AND PERFORM FIRST CYCLIC REDUNDANCY CHECK WITH RESPECT TO DECODED CODE BLOCK ── S200

↓

CONFIRM THAT FIRST CYCLIC REDUNDANCY CHECK ON DECODED CODE BLOCK HAS PASSED ── S210

↓

GENERATE TARGET BLOCK CORRESPONDING TO DECODED CODE BLOCK, BASED ON MEMORY MANAGEMENT INFORMATION CORRESPONDING TO DECODED CODE BLOCK ── S220

↓

GENERATE REMAINDER BY DIVIDING GENERATED TARGET BLOCK BY POLYNOMIAL FOR SECOND CYCLIC REDUNDANCY CHECK ── S230

↓

STORE GENERATED REMAINDER IN ANY ONE OF INTERNAL MEMORY AND REGISTER CIRCUIT, BASED ON MEMORY MANAGEMENT INFORMATION ── S240

↓

END

# FIG. 8A

INITIAL TRANSMISSION

| | MMG1 | | MMG2 | | MMG3 | |
|---|---|---|---|---|---|---|

| TB_I | R1 [CRC GOOD] | R2 [CRC GOOD] | R3 [CRC BAD] | R4 [CRC GOOD] | R5 [CRC BAD] | R6 [CRC GOOD] |

TGB12A    R1    '0' BITS

↓ 'S1' IS VALID

TGB22A    '0' BITS | S1 | R2    '0' BITS

↓ 'S2' IS VALID

TGB32A    '0' BITS | S2 | R3    '0' BITS

TGB42A    '0' BITS    R4    '0' BITS

↓ 'S4_1' IS VALID

TGB52A    '0' BITS | S4_1 | R5    '0' BITS

TGB62A    '0' BITS    R6

'S6_1' IS VALID ↓

# FIG. 8B

| INTERNAL MEMORY | | | 320 |

| CB_MEM[1] | CB_MEM[2] | CB_MEM[3] |
|---|---|---|
| S1->S2 | S4_1 | S6_1 |

① WRITE 'S1' TO 'CB_MEM[1]'
② READ 'S1' FROM 'CB_MEM[1]'
③ OVERWRITE 'S2' TO 'CB_MEM[1]'
④ WRITE 'S4_1' TO 'CB_MEM[2]'
⑤ WRITE 'S6_1' TO 'CB_MEM[3]'

① ② ③ ④ ⑤

CB CONCATENATION & TBCRC CIRCUIT — 312_1

312_2
MEMORY MANAGING CIRCUIT
312_3
MAPPING TABLE

| CB INDEX | PLACEMENT ORDER IN MMG | ADDRESS |
|---|---|---|
| #1 | 1ST ORDER | ADDR[1] |
| #2 | 2ND ORDER | ADDR[1] |
| #3 | 1ST ORDER | ADDR[2] |
| #4 | 2ND ORDER | ADDR[2] |
| #5 | 1ST ORDER | ADDR[3] |
| #6 | 2ND ORDER | ADDR[3] |

# FIG. 9A

RE-TRANSMISSION

| MMG1 | MMG2 | MMG3 |
|------|------|------|

TB_R

R3'
[CRC GOOD]

R5'
[CRC GOOD]

'S2' FROM INTERNAL MEMORY

TGB32B   '0' BITS   S2   R3'   '0' BITS

'S3_2' IS VALID

'S3_2_1' + 'S4_1' FROM INTERNAL MEMORY

TGB52B   '0' BITS   S4_1   R5'   '0' BITS

'S5_2' IS VALID

## FIG. 9B

INTERNAL MEMORY — 320

| CB_MEM[1] | CB_MEM[2] | CB_MEM[3] |
|-----------|-----------|-----------|
| S2 | S4_1->S4_2 | S6_1->S6_2 |

① ③ ⑤ ⑥ ⑧ ⑩

CB CONCATENATION & TBCRC CIRCUIT — 312_1

REG

S3_2->S5_2

② ④ ⑦ ⑨

MEMORY MANAGING CIRCUIT — 312_2

MAPPING TABLE — 312_3

① READ 'S2' FROM 'CB_MEM[1]'
② WRITE 'S3_2' TO 'REG'
③ READ 'S4_1' FROM 'CB_MEM[2]'
④ READ 'S3_2' FROM 'REG'
⑤ OVERWRITE 'S4_2' TO 'CB_MEM[2]'
⑥ READ 'S4_2' FROM 'CB_MEM[2]'
⑦ OVERWRITE 'S5_2' TO 'REG'
⑧ READ 'S6_1' FROM 'CB_MEM[3]'
⑨ READ 'S5_2' FROM 'REG'
⑩ OVERWRITE 'S6_2' TO 'CB_MEM[3]'

| CB INDEX | PLACEMENT ORDER IN MMG | ADDRESS |
|----------|------------------------|---------|
| #1 | 1ST ORDER | ADDR[1] |
| #2 | 2ND ORDER | ADDR[1] |
| #3 | 1ST ORDER | ADDR[2] |
| #4 | 2ND ORDER | ADDR[2] |
| #5 | 1ST ORDER | ADDR[3] |
| #6 | 2ND ORDER | ADDR[3] |

EP 4 738 736 A1

# FIG. 10A

INITIAL TRANSMISSION

# FIG. 10B

① WRITE 'S1' TO 'CB_MEM[1]'
② READ 'S1' FROM 'CB_MEM[1]'
③ OVERWRITE 'S2' TO 'CB_MEM[1]'
④ READ 'S2' FROM 'CB_MEM[1]'
⑤ WRITE 'S3' TO 'CB_MEM[2]'
⑥ WRITE 'S5_1' TO 'CB_MEM[3]'

**320**

INTERNAL MEMORY

| CB_MEM[1] | CB_MEM[2] | CB_MEM[3] |
|-----------|-----------|-----------|
| S1→S2 | S3 | S5_1 |

**312_1**

CB CONCATENATION & TBCRC CIRCUIT

REG
—

312_2
MEMORY MANAGING CIRCUIT
312_3
MAPPING TABLE

| CB INDEX | PLACEMENT ORDER IN MMG | ADDRESS |
|----------|------------------------|---------|
| #1 | 1ST ORDER | ADDR[1] |
| #2 | 2ND ORDER | ADDR[1] |
| #3 | 1ST ORDER | ADDR[2] |
| #4 | 2ND ORDER | ADDR[2] |
| #5 | 1ST ORDER | ADDR[3] |
| #6 | 2ND ORDER | ADDR[3] |

EP 4 738 736 A1

# FIG. 11A

RE-TRANSMISSION

MMG1          MMG2          MMG3

TB_R    | | | | R4' [CRC GOOD] | | R6' [CRC GOOD] |

'S3' FROM INTERNAL MEMORY

TGB43B   '0' BITS   S3   R4'   '0' BITS

'S4_2' IS VALID

'S4_2_1' + 'S5_1' FROM INTERNAL MEMORY

TGB63B   '0' BITS   S5_2   R6'

'S6_2' IS VALID

# FIG. 11B

INTERNAL MEMORY — 320

| CB_MEM[1] | CB_MEM[2] | CB_MEM[3] |
|-----------|-----------|-----------|
| S2 | S3->S4_2 | S5_1->S6_2 |

① READ 'S3' FROM 'CB_MEM[2]'
② OVERWRITE 'S4_2' TO 'CB_MEM[2]'
③ READ 'S4_2' FROM 'CB_MEM[2]'
④ READ 'S5_1' FROM 'CB_MEM[3]'
⑤ OVERWRITE 'S6_2' TO 'CB_MEM[3]'

① ② ③ ④ ⑤

CB CONCATENATION & TBCRC CIRCUIT — 312_1

REG
–

MEMORY MANAGING CIRCUIT — 312_2

MAPPING TABLE — 312_3

| CB INDEX | PLACEMENT ORDER IN MMG | ADDRESS |
|----------|------------------------|---------|
| #1 | 1ST ORDER | ADDR[1] |
| #2 | 2ND ORDER | ADDR[1] |
| #3 | 1ST ORDER | ADDR[2] |
| #4 | 2ND ORDER | ADDR[2] |
| #5 | 1ST ORDER | ADDR[3] |
| #6 | 2ND ORDER | ADDR[3] |

# FIG. 12

DECODE PLURALITY OF CODE BLOCKS IN UNITS OF CODE
BLOCKS AND PERFORM FIRST CYCLIC REDUNDANCY
CHECK ON EACH OF PLURALITY OF CODE BLOCKS

PERFORM SECOND CYCLIC REDUNDANCY CHECK,
BASED ON DECODING-COMPLETED CODE BLOCK,
BY USING INTERNAL MEMORY AND REGISTER CIRCUIT

t11          t21                                        t31          t41   TIME

# FIG. 13

EP 4 738 736 A1

# FIG. 14

| 720 | 710 | 70 |
|---|---|---|
| INTERNAL MEMORY & REGISTER CIRCUIT | HARQ PROCESSING CIRCUIT | EXTERNAL MEMORY |

PERFORM FIRST CYCLIC REDUNDANCY CHECK WITH RESPECT TO CODE BLOCKS — S300

TRANSMIT CODE BLOCKS THAT HAVE PASSED FIRST CYCLIC REDUNDANCY CHECK — S301

S302 — STORE RECEIVED CODE BLOCKS

GENERATE TARGET BLOCKS CORRESPONDING TO CODE BLOCKS — S303

PERFORM SECOND CYCLIC REDUNDANCY CHECK ON TRANSPORT BLOCK, BASED ON MODULAR ARITHMETIC WITH RESPECT TO TARGET BLOCKS — S304

TRANSMIT INTERMEDIATE DATA, BASED ON MEMORY MANAGEMENT INFORMATION — S305

READ INTERMEDIATE DATA, BASED ON MEMORY MANAGEMENT INFORMATION — S306

PERFORM SECOND CYCLIC REDUNDANCY CHECK ON TRANSPORT BLOCK, BASED ON RETRANSMITTED CODE BLOCKS AND READ-OUT INTERMEDIATE DATA — S307

READ CODE BLOCKS — S308

S309 — GENERATE CODEWORD-UNIT DECODED DATA BY CONCATENATING READ-OUT CODE BLOCKS TO RETRANSMITTED CODE BLOCKS

# FIG. 15

1000

1010

1012  DATA STORAGE

1011  PROGRAM STORAGE

1013  APPLICATION PROGRAM

1014  HARQ PROGRAM

1020

1021  MEMORY INTERFACE

1022  PROCESSOR

1023  PERIPHERAL DEVICE INTERFACE

1090  COMMUNICATION PROCESSOR

1040  INPUT/OUTPUT CONTROLLER

1050  DISPLAY

1060  INPUT DEVICE

EP 4 738 736 A1

# FIG. 16

HOME GADGET 2100

2120

HOME APPLIANCES

2200

ACCESS POINT

2140

ENTERTAINMENT

Europäisches
Patentamt

European
Patent Office

Office européen
des brevets

# EUROPEAN SEARCH REPORT

**Application Number**

EP 25 21 0212

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2018/287736 A1 (REN TIANMIN [US] ET AL) 4 October 2018 (2018-10-04) * paragraph [0021] - paragraph [0057]; figures 2,3,4,5 * | 1-15 | INV. H04L1/00 H03M13/09 H03M13/00 H04L1/1829 |
| A | CN 112 671 511 B (SHANGHAI RESEARCH INSTITUTE OF MICROWAVE TECH THE 50TH RESEARCH INSTIT) 18 March 2022 (2022-03-18) * paragraph [0054] - paragraph [0070]; figures 1,2,3,4 * | 1-15 | |

TECHNICAL FIELDS
SEARCHED (IPC)

H04L
H03M

The present search report has been drawn up for all claims

| Place of search | Date of completion of the search | Examiner |
|---|---|---|
| Munich | 5 March 2026 | Courville, Nicolas |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

& : member of the same patent family, corresponding
   document

EPO FORM 1503 03.82 (P04C01)

## ANNEX TO THE EUROPEAN SEARCH REPORT
## ON EUROPEAN PATENT APPLICATION NO.

EP 25 21 0212

This annex lists the patent family members relating to the patent documents cited in the above-mentioned European search report.
The members are as contained in the European Patent Office EDP file on
The European Patent Office is in no way liable for these particulars which are merely given for the purpose of information.

05-03-2026

| Patent document cited in search report | Publication date | Patent family member(s) | Publication date |
|---|---|---|---|
| US 2018287736 A1 | 04-10-2018 | NONE | |
| CN 112671511 B | 18-03-2022 | NONE | |

EPO FORM P0459

For more details about this annex : see Official Journal of the European Patent Office, No. 12/82